(19) Europäisches Patentamt
European Patent Office
Office européen des brevets

(11) EP 1 744 600 A1

(12) EUROPEAN PATENT APPLICATION
published in accordance with Art. 158(3) EPC

(43) Date of publication:
17.01.2007 Bulletin 2007/03

(21) Application number: 05728486.1

(22) Date of filing: 07.04.2005

(51) Int Cl.:
*H05B 33/24 (2006.01)* *H05B 33/12 (2006.01)*
*H05B 33/14 (2006.01)* *H05B 33/22 (2006.01)*

(86) International application number:
PCT/JP2005/006846

(87) International publication number:
WO 2005/109964 (17.11.2005 Gazette 2005/46)

(84) Designated Contracting States:
AT BE BG CH CY CZ DE DK EE ES FI FR GB GR HU IE IS IT LI LT LU MC NL PL PT RO SE SI SK TR

(30) Priority: 21.04.2004 JP 2004125052

(71) Applicant: IDEMITSU KOSAN CO., LTD.
Tokyo 100-8321 (JP)

(72) Inventors:
- KUMA, Hitoshi
2990293 (JP)
- TOKAILIN, Hiroshi
2990293 (JP)
- YAMAMICHI, Keiko
2990293 (JP)
- FUKUOKA, Kenichi
2990293 (JP)
- YUASA, Kimihiro
2990293 (JP)
- HOSOKAWA, Chishio
2990293 (JP)

(74) Representative: Gille Hrabal Struck Neidlein Prop Roos
Brucknerstrasse 20
40593 Düsseldorf (DE)

# (54) ORGANIC ELECTROLUMINESCENCE DISPLAY DEVICE

(57) An organic electroluminescent display comprising a first organic electroluminescent device (10) wherein an optical distance between first (12) and second (14) reflecting members is set to select light of a first color, a second organic electroluminescent device (20) wherein an optical distance between first (12) and second (14) reflecting members is set to select light of a second color, and a third organic electroluminescent device (30) wherein an optical distance between first (12) and second (14) reflecting members is set to select light of a third color, the first reflecting member (12) having an average reflectance of 65% or more for light having a wavelength of 400 nm to 700 nm.

FIG. 1

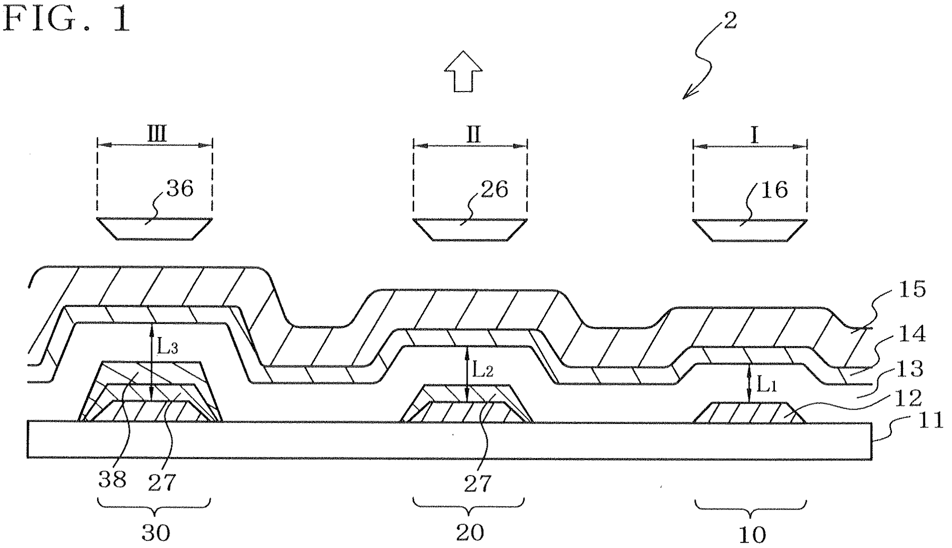

## Description

Technical Field

The invention relates to an organic electroluminescent (EL) display, particularly full-color organic EL display using a white organic electroluminescent medium layer.

Background Art

As technology of forming a full-color display using organic electroluminescence, a three-color pattern formation method, a method of combining white EL with a color filter, a color conversion method of combining EL with a color conversion film and the like have been known.
The three-color pattern formation method may achieve a high efficiency by adjusting the material balance and reducing the loss caused by a circular polarizer. However, since it is difficult to realize a high-resolution display using the three-color pattern formation method due to difficulty in forming a three-color pattern, it is considered that a large-screen display cannot be formed.
On the other hand, the white EL/color filter method and color conversion method can use a common organic EL emitting layer and this easily enables large-screen and high-resolution display. These methods have been therefore expected.
The full-color display method of an organic EL display is divided into a bottom-emission structure and a top-emission structure. In the top-emission structure, light is outcoupled from the side opposite to a substrate, differing from a related-art structure in which light is outcoupled through a substrate supporting an organic EL device. This improves the aperture ratio with respect to an emitting part, whereby the luminance can be increased.
A method has been studied in which a semitransparent cathode is used as an upper electrode and only light having a specific wavelength is outcoupled from the EL device utilizing a multiple interference effect to achieve high color reproducibility. For example, patent document 1 discloses an organic EL device in which a first electrode formed of a light reflecting material, an organic layer including an organic luminescent medium layer, and a second electrode formed of a semitransparent reflecting layer and a transparent material are stacked such that the organic layer serves as a resonator, and which satisfies the following formula when λ is the peak wavelength of the spectrum of light to be outcoupled.
$$(2L)/\lambda+\varphi/(2\pi) = m$$

wherein L is an optical length, λ is a wavelength of light to be outcoupled, m is an integer, φ is a phase shift, and the optical length L is adjusted to be minimized.
As examples of the first electrode formed of a light reflecting material, patent document 2 discloses metals belonging to the periodic table V and VI groups, specifically metals with a work function of 4.8 eV or less such as chromium, molybdenum, tungsten, tantalum, or niobium.
Patent document 3 discloses a display where in each of R, G, and B pixels, an organic EL device is placed between a reflecting layer and a transparent layer, and a color filter is disposed on the light-outcoupling side or the external light incident side of the transparent layer.
Patent document 1: WO 01/39554
Patent document 2: JP-A-2001-43980
Patent document 3: JP-A-2002-373776

However, the above organic EL devices or organic EL displays have the following problems.
Specifically, since a metal such as chromium, molybdenum, tungsten, tantalum, or niobium used for the reflecting electrode cannot ensure a sufficient optical resonator effect, a further improvement is required for the efficiency of the display.
Since the patent document 1 discloses only an organic layer having a single optical thickness which satisfies the above expression, it is difficult to efficiently apply such an organic layer to a full-color display in which light of three colors with different wavelengths is outcoupled.
The invention has been achieved in view of the above-described problems. An object of the invention is to provide an

organic EL display which can achieve highly efficient full-color display.

Disclosure of the Invention

Through an intensive study, the inventors found that multicolor emission with a high efficiency can be obtained by combining organic EL devices containing three emitting materials exhibiting different emission color and a specific metal electrode with a high reflectance with three color filters facing the devices, and completed the invention.
The invention provides the following organic EL display.

1. An organic electroluminescent display comprising:

a first pixel comprising a first organic electroluminescent device and a first color filter which transmits light of a first color emitted from the first organic electroluminescent device, provided in that order in a light-outcoupling direction;
a second pixel comprising a second organic electroluminescent device and a second color filter which transmits light of a second color emitted from the second organic electroluminescent device, provided in that order in the light-outcoupling direction; and
a third pixel comprising a third organic electroluminescent device and a third color filter which transmits light of a third color emitted from the third organic electroluminescent device, provided in that order in the light-outcoupling direction;
the first organic electroluminescent device comprising at least a first reflecting member and a second reflecting member in that order in the light-outcoupling direction, and at least first and second electrodes and an organic luminescent medium layer between a first and second electrodes between the first and second reflecting members, an optical distance between the first and second reflecting members being set to select light of the first color;
the second organic electroluminescent device comprising at least a first reflecting member and a second reflecting member in that order in the light-outcoupling direction, and at least first and second electrodes and an organic luminescent medium layer between a first and second electrodes between the first and second reflecting members, an optical distance between the first and second reflecting members being set to select light of the second color;
the third organic electroluminescent device comprising at least a first reflecting member and a second reflecting member in that order in the light-outcoupling direction, and at least first and second electrodes and an organic luminescent medium layer between a first and second electrodes between the first and second reflecting members, an optical distance between the first and second reflecting members being set to select light of the third color;
the first reflecting member having an average reflectance of 65% or more for light having a wavelength of 400 nm to 700 nm; and
the organic luminescent medium layer emitting light of at least the first color, the second color and the third color.

2. The organic electroluminescent display according to 1 wherein the first reflecting member and the second reflecting member are a first electrode and a second electrode, respectively, or a first electrode and a second electrode are provided between the first reflecting member and the second reflecting member; and
the organic luminescent medium layer is positioned between the first electrode and the second electrode.
3. An organic electroluminescent display comprising:

a first pixel comprising a first organic electroluminescent device and a first color filter which transmits light of a first color emitted from the first organic electroluminescent device, provided in that order in a light-outcoupling direction;
a second pixel comprising a second organic electroluminescent device and a second color filter which transmits light of a second color emitted from the second organic electroluminescent device, provided in that order in the light-outcoupling direction; and
a third pixel comprising a third organic electroluminescent device and a third color filter which transmits light of a third color emitted from the third organic electroluminescent device, provided in that order in the light-outcoupling direction;
the first organic electroluminescent device sequentially comprising at least a reflecting electrode, organic luminescent medium layer, metal layer and transparent electrode layer in the light-outcoupling direction,
the second organic electroluminescent device sequentially comprising at least a reflecting electrode, first optical thickness adjustment layer, organic luminescent medium layer, metal layer and transparent electrode layer in the light-outcoupling direction,
the third organic electroluminescent device sequentially comprising at least a reflecting electrode, second optical

thickness adjustment layer, organic luminescent medium layer, metal layer and transparent electrode layer in the light-outcoupling direction,

the reflecting electrode having an average reflectance of 65% or more for light having a wavelength of 400 nm to 700 nm; and

the organic luminescent medium layer emitting light of at least the first color, the second color and the third color.

4. The organic electroluminescent display according to 3 wherein the organic luminescent medium layer contains a first emitting material emitting light of the first color, a second emitting material emitting light of the second color and a third emitting material emitting light of the third color.

5. The organic electroluminescent display according to 3 or 4 wherein the first optical thickness adjustment layer comprises a first inorganic compound layer, and the second optical thickness adjustment layer comprises the first inorganic compound layer and a second inorganic compound layer.

6. An organic electroluminescent display comprising:

a first pixel comprising a first organic electroluminescent device and a first color filter which transmits light of a first color emitted from the first organic electroluminescent device, provided in that order in a light-outcoupling direction;

a second pixel comprising a second organic electroluminescent device and a second color filter which transmits light of a second color emitted from the second organic electroluminescent device, provided in that order in the light-outcoupling direction; and

a third pixel comprising a third organic electroluminescent device and a third color filter which transmits light of a third color emitted from the third organic electroluminescent device, provided in that order in the light-outcoupling direction;

the first organic electroluminescent device sequentially comprising at least a reflecting electrode, first optical thickness adjustment layer, organic luminescent medium layer, metal layer and transparent electrode layer in the light-outcoupling direction,

the second organic electroluminescent device sequentially comprising at least a reflecting electrode, second optical thickness adjustment layer, organic luminescent medium layer, metal layer and transparent electrode layer in the light-outcoupling direction,

the third organic electroluminescent device sequentially comprising at least a reflecting electrode, third optical thickness adjustment layer, organic luminescent medium layer, metal layer and transparent electrode layer in the light-outcoupling direction,

the reflecting electrode having an average reflectance of 65% or more for light having a wavelength of 400 nm to 700 nm; and

the organic luminescent medium layer emitting light of at least the first color, the second color and the third color.

7. The organic electroluminescent display according to 6 wherein the organic luminescent medium layer contains a first emitting material emitting light of the first color, a second emitting material emitting light of the second color and a third emitting material emitting light of the third color.

8. The organic electroluminescent display according to 6 or 7 wherein the first optical thickness adjustment layer comprises a first inorganic compound layer, the second optical thickness adjustment layer comprises the first inorganic compound layer and a second inorganic compound layer, and the third optical thickness adjustment layer comprises the first inorganic compound layer, the second inorganic compound layer and a third inorganic compound layer.

9. The organic electroluminescent display according to any one of 1 to 8 wherein the organic luminescent medium layer sequentially comprises a blue emitting layer including a host material and a blue dopant, a green emitting layer including the same host material as in the blue emitting layer and a green dopant and an orange-to-red emitting layer including the same host material as in the blue emitting layer and an orange-to-red dopant.

10. The organic electroluminescent display according to 9
wherein the host material used for the organic luminescent medium layer is an asymmetric anthracene compound.

11. The organic electroluminescent display according to 9 or 10 wherein the blue dopant used for the organic luminescent medium is at least a compound selected from styrylamine, amine-substituted styryl compounds, amine-substituted condensed aromatic compounds and condensed aromatic ring-containing compounds.

12. The organic electroluminescent display according to any one of 9 to 11 wherein the orange-to-red dopant used for the organic luminescent medium is at least a compound selected from compounds having a plurality of fluoranthene skeletons.

According to the invention, an organic EL display capable of full-color display with a high efficiency can be

provided.

Brief Description of Drawings

Fig. 1 is a view showing an organic EL display according to embodiment 1.
Fig. 2a is a view showing a step of a method for fabricating an organic EL device substrate for the organic EL display according to embodiment 1.
Fig. 2b is a view showing a step of a method for fabricating an organic EL device substrate for the organic EL display according to embodiment 1.
Fig. 2c is a view showing a step of a method for fabricating an organic EL device substrate for the organic EL display according to embodiment 1.
Fig. 2d is a view showing a step of a method for fabricating an organic EL device substrate for the organic EL display according to embodiment 1.
Fig. 2e is a view showing a step of a method for fabricating an organic EL device substrate for the organic EL display according to embodiment 1.
Fig. 2f is a view showing a step of a method for fabricating an organic EL device substrate for the organic EL display according to embodiment 1.
Fig. 2g is a view showing a step of a method for fabricating an organic EL device substrate for the organic EL display according to embodiment 1.
Fig. 2h is a view showing a step of a method for fabricating an organic EL device substrate for the organic EL display according to embodiment 1.
Fig. 2i is a view showing a step of a method for fabricating an organic EL device substrate for the organic EL display according to embodiment 1.
Fig. 3 is a view showing an organic EL display according to embodiment 2.
Fig. 4 is a view showing the reflectance of light reflecting electrodes of an example and a comparative example.
Fig. 5 is a view showing the luminescence spectrum of blue pixels of an example and a comparative example.
Fig. 6 is a view showing the luminescence spectrum of green pixels of an example and a comparative example.
Fig. 7 is a view showing the luminescence spectrum of red pixels of an example and a comparative example.

Preferred Embodiments of the Invention

First embodiment

FIG. 1 is a view showing an organic EL display according to a first embodiment of the invention.
In an organic EL display 1, different organic EL devices 10, 20, and 30 are juxtaposed.
The organic EL device 10 has a structure in which a reflecting electrode 12 serving as a first reflecting member and a first electrode, an organic luminescent medium layer 13, and a stacked film of a metal layer 14 and a transparent electrode 15 serving as a second reflecting member and a second electrode are stacked in that order in the light-outcoupling direction.
The reflecting electrode 12 is a layer which functions as an electrode which supplies holes or electrons and reflects light from the organic luminescent medium layer 13 in the light-outcoupling direction. The reflecting electrode has an average reflectance of light having a wavelength of 400 nm to 700 nm of 65% or more, preferably 70% or more, and still more preferably 85% or more.
The organic luminescent medium layer 13 is a layer which emits light upon recombination of electrons and holes. The organic luminescent medium layer 13 emits light of at least a first color, a second color, and a third color. The organic luminescent medium layer 13 contains at least a first emitting material emitting light of the first color and a second emitting material emitting light of the second color, and preferably contains the first emitting material emitting light of the first color, the second emitting material emitting light of the second color, and a third emitting material emitting light of the third color. When the number of emitting materials contained in the organic luminescent medium layer 13 is two, the first emitting material may emit light of the first color and light of the second color at the same time, or the second emitting material may emit light of the second color and light of the third color at the same time. In either case, light outcoupled from the organic EL device includes light of the first, second, and third colors. The organic luminescent medium layer 13 may emit light of a color other than the first, second, and third colors.
The first, second, and third colors are preferably blue with a wavelength of 400 nm to 500 nm, green with a wavelength of 500 nm to 570 nm, and red with a wavelength of 570 nm to 700 nm. Note that the first, second, and third colors are not limited thereto. A subtle color expression may be realized by combining various three colors.

The stacked film of the metal layer 14 and the transparent electrode 15 functions as the second electrode which supplies holes or electrons and as the second reflecting layer which reflects and transmits light from the organic luminescent medium layer 13.
A first color filter 16 is provided facing to the organic EL device 10 in the light-outcoupling direction indicated by the arrow. The first color filter transmits light of the first color.
The organic EL device 10 and the first color filter 16 make up a first pixel I.
The organic EL device 20 has a structure in which the reflecting electrode 12 serving as the first reflecting member and the first electrode, a first inorganic compound layer 27, the organic luminescent medium layer 13, and the stacked film of the metal layer 14 and the transparent electrode 15 serving as the second reflecting member and the second electrode are stacked in that order in the light-outcoupling direction. The first inorganic compound layer 27 corresponds to a first optical thickness adjustment layer.
A second color filter 26 is provided facing to the organic EL device 20 in the light-outcoupling direction indicated by the arrow. The second color filter transmits light of the second color.
The organic EL device 20 and the second color filter 26 make up a second pixel II.
The organic EL device 30 has a structure in which the reflecting electrode 12 serving as the first reflecting member and the first electrode, the first inorganic compound layer 27, a second inorganic compound layer 37, the organic luminescent medium layer 13, and the stacked film of the metal layer 14 and the transparent electrode 15 serving as the second reflecting member and the second electrode are stacked in that order in the light-outcoupling direction. The first inorganic compound layer 27 and the second inorganic compound layer 38 correspond to a second optical thickness adjustment layer.
A third color filter 36 is provided facing to the organic EL device 30 in the light-outcoupling direction indicated by the arrow. The third color filter transmits light of the third color.
The organic EL device 30 and the third color filter 36 make up a third pixel III.
Note that the first reflecting member and the first electrode need not be identical. The first reflecting member and the first electrode may be separated in the light-outcoupling direction, or an insulating reflecting layer and an electrode may be stacked in that order in the light-outcoupling direction. As specific examples of the insulating reflecting layer, a stacked layer of a reflecting layer formed of a metal film and an insulating optical thickness adjustment layer, and a multilayer film of a high-refractive-index dielectric layer and a low-refractive-index dielectric layer known as a dielectric laser mirror can be given. As examples of the material for forming the high-refractive-index dielectric layer, metal oxides such as $ZrO_2$, $CeO_2$, and $Ta_2O_3$ and II-VI group compounds such as ZnS and CdS can be given. As examples of the material for forming the low-refractive-index dielectric layer, metal fluorides such as $CaF_2$ and $AlF_3$ can be given.
The second reflecting member is not limited to the stacked film of the metal layer and the transparent electrode stacked in that order. The metal layer and the transparent electrode may be stacked in the reverse order. The second reflecting member need not be a metal layer.
The second reflecting member may be an insulating film such as the dielectric multilayer film given above.
In FIG. 1, only the organic luminescent medium 13 is provided between the two electrodes 12 and 15 so that the invention is readily understood. In general, an electron injecting layer, an electron transporting layer, a hole injecting layer, a hole transporting layer, and the like are further provided between the electrodes 12 and 15, as described later.
In order to prevent deterioration of the organic EL device 10 due to oxygen, water, and other volatile components contained in the environment or the color filters 16, 26, and 36, a sealing layer or the like may be provided between the transparent electrode layer 15 and the color filters 16, 26, and 36. As the sealing layer, a transparent inorganic compound layer such as $SiO_xN_y$, $AlO_xN_y$, or $SiAlO_xN_y$, a layer in which such a transparent inorganic compound layer and a transparent resin or a sealing liquid are stacked, or the like may be used.
The operation of the organic EL display 1 is described below.
The organic EL devices 10, 20, and 30 have an optical resonator structure in which a resonator is formed between the first reflecting member (reflecting electrode 12) and the second reflecting member (metal layer 14). In such a resonator structure, light from the organic luminescent medium 13 is repeatedly reflected between two reflecting surfaces (reflecting electrode 12 and metal layer 14) so that light having a wavelength satisfying the following expression is selectively enhanced and outcoupled from the device.

$$(2L)/\lambda+\Phi/(2\pi)=m$$

Where L indicates the optical distance of the resonator, $\lambda$ indicates the wavelength of light, $\Phi$ indicates the sum of the phase shifts at the two reflecting member interface, and m indicates an integer of zero or more.
The optical distance L is the product of the refractive index n and the actual geometrical distance $L_R$ of the medium through which light passes.

Specifically, light from the organic luminescent medium 13 having the wavelength $\lambda$ satisfying the above expression is selectively enhanced and outcoupled from the device through the metal layer 14 and the transparent electrode 15.

In FIG. 1, $L_1$ schematically indicates the optical distance of the first organic EL device 10, $L_2$ schematically indicates the optical distance of the second organic EL device 20, and $L_3$ schematically indicates the optical distance of the third organic EL device 30.

The optical distances $L_1$ and $L_2$ differ in an amount corresponding to the optical distance of the first inorganic compound layer 27, and the optical distances $L_2$ and $L_3$ differ in an amount corresponding to the optical distance of the second inorganic compound layer 38.

Specifically, the optical distance can be set for the first organic EL device 10 so that light having a specific wavelength $\lambda_1$ is enhanced and outcoupled from the device, the optical distance can be set for the second organic EL device 20 so that light having a specific wavelength $\lambda_2$ is enhanced and outcoupled from the device, and the optical distance can be set for the third organic EL device 30 so that light having a specific wavelength $\lambda_3$ is enhanced and outcoupled from the device by adjusting the refractive indices or the thicknesses of the inorganic compound layers 27 and 38. This allows light having a desired wavelength to be respectively enhanced and outcoupled from the three devices, whereby effective multicolor emission can be achieved.

Next, a method for producing the organic EL device substrate of the embodiment will be described referring to Fig.2. An example will be described below where the substrate is produced by a method including wet etching. Note that a method for producing the substrate is not limited to the following method.

A material for a light reflective conductive layer 12 is sputtered to form a film on a substrate 11 (FIG. 2(a)), followed by etching into a desired pattern by photolithography and the like (FIG. 2(b)).

Next, a material for a first inorganic compound layer 27 is sputtered to form a film (FIG. 2(c)) and an unnecessary part is etched with an etchant similarly to the above, thereby forming first inorganic compound layers 27 on light reflective conductive layers 12 of second and third organic EL devices 20 and 30 (FIG. 2(d)).

The first inorganic compound layer 27 can be formed without etching the light reflective conductive layer 12 which has been formed by selecting materials to be easily etched in the order from a second inorganic compound layer 38, a first inorganic compound layer 27 and a light reflective conductive layer 12.

After forming a film of the material for the second inorganic compound layer 38 by sputtering (FIG. 2e), unnecessary portions are removed by etching using an etchant to form the second inorganic compound layer 38 on the first inorganic compound layer 27 of the third organic EL device 30 (FIG. 2f).

The organic luminescent medium layer 13 (FIG. 2g), the metal layer 14 (FIG. 2h), and the transparent electrode layer 15 (FIG. 2i) are formed in that order on the substrate on which the reflecting conductive layer 12 and each inorganic compound layer are formed to fabricate an organic EL device.

This method ensures easy fabrication of an organic EL device substrate.

The formation method for each layer of the organic EL device is not particularly limited. Each layer may be formed using a known method such as sputtering, vacuum deposition, molecular beam epitaxy (MBE), or a coating method using a solution in which the material is dissolved in a solvent, such as dipping, spin coating, casting, bar coating, or roll coating.

In this example, since an effective optical resonator effect is provided in each pixel by using the electrode with a high reflectance and changing the optical distance in each pixel, the light-outcoupling efficiency of each pixel is increased. Therefore, the luminous efficiency and the chromatic purity of the display can be improved.

In this example, the chromatic purity of the display can be further improved by combining the white organic EL device including the three primary colors and the color filters.

In this organic EL display, the organic luminescent medium layer 13, the metal layer 14, and the transparent electrode layer 15 can be respectively formed as single common films. This is extremely advantageous from the viewpoint of industrial production since the production process can be simplified.

Second embodiment

FIG. 3 is a view showing an organic EL display according to a second embodiment of the invention.

The second embodiment differs from the first embodiment in that a third inorganic compound layer 19 is formed on the reflecting electrode 12 in the organic EL device 10 of the first pixel I, the third inorganic compound layer 19 and the first inorganic compound layer 27 are formed on the reflecting electrode 12 in the organic EL device 20 of the second pixel II, and the first inorganic compound layer 27, the second inorganic compound layer 38, and the third inorganic compound layer 19 are formed on the reflecting electrode 12 in the organic EL device 30 of the third pixel III.

The third inorganic compound layer 19 corresponds to the first optical thickness adjustment layer, the first inorganic compound layer 27 and the third inorganic compound layer 19 correspond to the second optical thickness adjustment layer, and the first inorganic compound layer 27, the second inorganic compound layer 38, and the third inorganic compound layer 19 correspond to the third optical thickness adjustment layer.

The third inorganic compound layer 19 is provided to adjust the optical thickness, improve the adhesion between the

organic luminescent medium layer 13 and the reflecting electrode 12, and improve the capability of injecting carries into the organic luminescent medium. As preferred inorganic compounds used for the inorganic compound layer, alkali metal oxides, alkaline earth oxides, rare earth oxides, alkali halides, alkaline earth halides, rare earth halides, and oxides, nitrides, and oxynitrides such as $SiO_x$, $AlO_x$, $SiN_x$, SiON, AlON, $GeO_x$, $LiO_x$, LiON, $TiO_x$, TiON, $TaO_x$, TaON, $TaN_x$, and C can be given.

In particular, when the reflecting electrode 12 functions as the anode, it is preferable to use $SiO_x$, $AlO_x$, $SiN_x$, SiON, AlON, $GeO_x$, C, ITO, IZO, $InO_x$, $ZnO_x$, or ICO (cerium oxide) since a stable injection interface layer is formed. The thickness of the third inorganic compound layer 19 is not particularly limited. The thickness of the third inorganic compound layer 19 is preferably 0.1 nm to 100 nm.

In FIG. 3, $L_1$ schematically indicates the optical distance (optical thickness obtained by multiplying the refractive index by the actual thickness) of the first organic EL device 10, $L_2$ schematically indicates the optical distance of the second organic EL device 20, and $L_3$ schematically indicates the optical distance of the third organic EL device 30 in the same manner as in FIG. 1.

The optical distances $L_1$ and $L_2$ differ in an amount corresponding to the optical distance of the first inorganic compound layer 27, and the optical distances $L_2$ and $L_3$ differ in an amount corresponding to the optical distance of the second inorganic compound layer 38.

Specifically, the optical distance can be set for the first organic EL device 10 so that light having a specific wavelength $\lambda_1$ is enhanced and outcoupled from the device, the optical distance can be set for the second organic EL device 20 so that light having a specific wavelength $\lambda_2$ is enhanced and outcoupled from the device, and the optical distance can be set for the third organic EL device 30 so that light having a specific wavelength $\lambda_3$ is enhanced and outcoupled from the device by adjusting the refractive indices or the thicknesses of the inorganic compound layers 19, 27, and 38. This allows light having a desired wavelength to be respectively enhanced and outcoupled from the three devices, whereby effective multicolor emission can be achieved.

In the first and third embodiments, the optical thickness adjustment layer is a single layer or a laminate of two or three layers. Note that the optical thickness adjustment layer may be formed of an arbitrary number of layers insofar as the desired optical thickness is obtained.

The members of the organic EL display according to the invention are described below.

(1) Reflecting electrode

As the material for the reflecting electrode, a metal film having an average reflectance of light having a wavelength of 400 nm to 700 nm of 65% or more is preferably selected. The reflectance of the metal film is determined by the thickness d, the complex refractive index n-iK, and the surface roughness (RMS roughness) o. As the material for the metal film, a material of which the real part n and the imaginary part K (corresponding to the optical absorption coefficient) of the complex refractive index are small is preferable. As specific examples of such a material, metal films and alloy films of Au, Ag, Cu, Mg, Al, Ni, Pd, and the like can be given.

If the thickness d is small, since light passes through the metal film, the reflectance decreases. It is preferable that the thickness of the metal film be 50 nm or more, although the thickness varies depending on the value of the imaginary part K of the complex refractive index of the metal used.

If the surface roughness $\sigma$ is large, light undergoes diffused reflection so that the amount of components reflected in the direction perpendicular to the emission surface of the organic EL device decreases. Therefore, the surface roughness $\sigma$ is preferably less than 10 nm, and still more preferably less than 5 nm.

(2) Inorganic compound layer

Any material which has a light transmittance of 50% or more in the wavelength region of visible light (380 nm to 780 nm) can be used for an inorganic compound layer without particular limitation. Materials with a light transmittance of 80% or more are preferred.

Inorganic compounds include inorganic oxides, for example oxides of In, Sn, Zn, Ce, Sm, Pr, Nb, Tb, Cd, Ga, Al, Mo and W, preferably oxides containing In, Sn, Zn or Ce.

It is preferable that the materials used for the light reflective conductive layer, the first inorganic compound layer, and the second inorganic compound layer differ in etching properties in order to facilitate production of the display. Specifically, it is preferable to select a material which is easily etched in the order from the third inorganic compound layer, the second inorganic compound layer, the first inorganic compound layer, and the light reflective conductive layer. For example, a material which is etched using a weaker acid than that used for the material for the light reflective conductive layer is selected for the first inorganic compound layer, a material which is etched using a weaker acid than that used for the material for the first inorganic compound layer is selected for the second inorganic compound layer, and a material which is etched using a weaker acid than that used for the material for the second inorganic compound

layer is selected for the third inorganic compound layer.
Note that a material which allows each layer to be selectively etched using a specific etchant may be selected.

In order to allow the inorganic compound layers to differ in etching properties, the crystallinity of the inorganic oxides which form these compound layers may be adjusted. The compound layer tends to be less etched using an acid as the crystallinity of the compound layer becomes higher.
In the invention, the inorganic compound layers can have different etching properties by causing the crystallinity thereof to differ from each other.

As an example utilizing the difference in etching properties, an example using wet etching is given below.
A Cr film is formed on a glass substrate by sputtering to form a light reflective conductive layer. The substrate is subjected to etching using a mixture of ceric ammonium nitrate-hydrogen peroxide aqueous solution (CAN) to obtain a substrate provided with the patterned light reflective conductive layer.
An ITO film is formed by sputtering and etched using an oxalic acid aqueous solution to obtain a substrate provided with the patterned amorphous (noncrystalline) ITO film.
The substrate is heated at 230°C for 30 minutes to obtain a substrate provided with the crystalline ITO film (first inorganic compound layer). A layer which is not etched using an oxalic acid aqueous solution can be formed by forming the crystalline ITO film.
An IZO film is formed thereon by sputtering and etched using an oxalic acid aqueous solution to obtain a substrate provided with a patterned second inorganic compound layer. Noncrystalline ITO may also be used for the second inorganic compound layer.

The crystallinity may be determined by X-ray diffraction measurement. Specifically, X-rays are applied to the surface of the sample, and the angle ($2\theta$) and the intensity of the diffraction line are measured. The crystallinity is determined from the integrated intensity ratio of the diffraction peaks.

It is also preferable that the first inorganic compound layer be crystalline and the second inorganic compound layer be noncrystalline. This allows the second inorganic compound layer to be easily etched using a weaker acid than that used for the first inorganic compound layer.

As examples of the inorganic compound which is most easily etched using a weak acid, indium zinc oxide (IZO), a material obtained by adding a lanthanoid metal oxide to IZO, and the like can be given. As examples of the lanthanoid metal oxide, cerium oxide, praseodymium oxide, neodymium oxide, samarium oxide, europium oxide, gadolinium oxide, terbium oxide, dysprosium oxide, holmium oxide, erbium oxide, thulium oxide, ytterbium oxide, lutetium oxide, and the like can be given.
The content of the lanthanoid metal oxide is preferably 0.1 to 10 atomic percent of the total metal atoms of the metal oxide in the metal oxide layer.
It is also preferable to use noncrystalline indium tin oxide (ITO) obtained by sputtering ITO in the presence of hydrogen or the like.

As examples of the material which can be more easily etched using a weak acid than the light reflective conductive layer and is etched to a smaller extent than the above inorganic compound, ITO, an indium oxide-cerium oxide compound (ICO), an indium oxide-tungsten oxide compound, an indium oxide-molybdenum oxide compound, and the like can be given. Noncrystalline ITO and a noncrystalline substance of the above compound are also preferable. Since noncrystalline ITO and a noncrystalline substance of the above compound can be converted into a crystalline compound by thermal annealing, as described above, these compounds are particularly suitable when forming the second inorganic compound layer on the first inorganic compound layer.

It is preferable to form the first inorganic compound layer using ITO and form the second inorganic compound layer using IZO, since damage to the underlayer can be reduced during etching.

The thicknesses of the first inorganic compound layer and the second inorganic compound layer may be appropriately adjusted such that light having a desired wavelength resonates in the resonator of each EL device part. The thicknesses thereof are preferably 5 nm to 1000 nm.

(3) Configuration of emitting layer

The emitting layer is a layer provided between the reflecting electrode, and the metal layer and the transparent electrode layer, and includes at least the organic luminescent medium layer.
In order to improve chromatic purity which is important when using the organic EL display as a full-color display, the organic luminescent medium layer preferably includes a first emitting material which emits light of a color corresponding to the color of light transmitted through the first color filter, a second emitting material which emits light of a color corresponding to the color of light transmitted through the second color filter, and a third emitting material which emits light of a color corresponding to the color of light transmitted through the third color filter.

It suffices that the organic luminescent medium layer include three emitting materials which emit light of different colors. When the organic luminescent medium layer is formed by stacking three layers (blue emitting layer, green emitting

layer, and orange-to-red emitting layer), the following configuration may be stacked on the anode layer as the reflecting electrode.

(i) Blue emitting layer/green emitting layer/orange-to-red emitting layer
(ii)Hole-transparting layer/blue emitting layer/green emitting layer/orange-to-red emitting layer
(iii) Blue emitting layer/green emitting layer/orange-to-red emitting layer/electron-transporting layer
(iv) Hole-transporting layer/blue emitting layer/green emitting layer/orange-to-red emitting layer/electron-transporting layer
(v) Hole-injecting layer/hole-transporting layer/blue emitting layer/green emitting layer/orange-to-red emitting layer/electron-transporting layer
(vi)Hole-injecting layer/hole-transporting layer/blue emitting layer/green emitting layer/orange-to-red emitting layer/electron-transporting layer/electron-injecting layer
(vii) Hole-injection-supporting layer/hole-injecting layer/hole-transporting layer/blue emitting layer/green emitting layer/orange-to-red emitting layer/electron-transporting layer/electron-injecting layer
(viii) Hole-injecting layer/hole-transporting layer/blue and green mixture emitting layer/orange-to-red emitting layer/electron-transporting layer/electron injecting layer
(ix)Hole-injecting layer/hole-transporting layer/blue emitting layer/green and orange-to-red mixture emitting layer/electron-transporting layer/electron-injecting layer
(x) Hole-injecting layer/hole-transporting layer/blue and green mixture emitting layer/blue and orange-to-red mixture emitting layer/electron-transporting layer/electron-injecting layer

Of these, the configuration (vi) or (vii) is preferably used due to higher luminous efficiency and excellent durability. The blue emitting layer, the green emitting layer, and the orange-to-red emitting layer is formed of a host material doped with a dopant material which emits light of the respective color.
The blue-green mixture emitting layer in the configurations (viii) and (x) may be formed of a host material doped with a dopant material having a broad emission spectrum from blue to green, or a material obtained by doping a host material which emits blue light with a small amount of dopant material which emits green light.
The green-orange-to-red mixture emitting layer in the configuration (ix) may be formed of a host material doped with a dopant material having a broad emission spectrum from green to orange to red, or a material obtained by doping a host material which emits green light with a small amount of dopant material which emits orange to red light.
The blue-orange-to-red mixture emitting layer in the configuration (x) may be formed of a material obtained by doping a host material which emits blue light with a small amount of dopant material which emits orange to red light.
In the above configurations (i) to (x), the emitting layers are provided in the order of the blue emitting layer, the green emitting layer, and the orange-to-red emitting layer. According to such an order, since the blue emitting layer is provided on the anode side, the tendency in which the color of light becomes green or red can be eliminated. Therefore, since it is unnecessary to suppress light of green or orange to red in order to obtain ideal white for a full-color display, it is unnecessary to reduce the thickness or the doping concentration of the green or orange-to-red emitting layer in comparison with the blue emitting layer. As a result, since the thickness of the green or orange-to-red emitting layer can be increased in comparison with a known configuration, a change in chromaticity is reduced. Moreover, since an identical substance can be used as the host material for the blue emitting layer, the green emitting layer, and the orange-to-red emitting layer, the blue emitting region is rarely concentrated at the interface, whereby the luminescent performance is affected to only a small extent due to a change in thickness. In addition, since the orange-to-red emitting layer has a sufficiently large thickness, the luminescent performance is affected to only a small extent due to a change in thickness.
In the invention, the order of the emitting layers is not limited to the blue emitting layer, the green emitting layer, and the orange-to-red emitting layer. The emitting layers may be stacked in another order. The dopant material may be doped into the hole transporting layer or the electron transporting layer.
The thickness of the blue emitting layer is preferably 5 to 30 nm, and still more preferably 5 to 20 nm. If the thickness of the blue emitting layer is less than 5 nm, it may be difficult to form an emitting layer and adjust chromaticity. If the thickness of the blue emitting layer exceeds 30 nm, the driving voltage may be increased.
The thickness of the green emitting layer is preferably 5 to 30 nm, and still more preferably 5 to 20 nm. If the thickness of the green emitting layer is less than 5 nm, luminous efficiency may be decreased. If the thickness of the green emitting layer exceeds 30 nm, the driving voltage may be increased.
The thickness of the orange-to-red emitting layer is preferably 5 to 40 nm, and still more preferably 10 to 30 nm. If the thickness of the orange-to-red emitting layer is less than 5 nm, luminous efficiency may be decreased.
If the thickness of the orange-to-red emitting layer exceeds 40 nm, the driving voltage may be increased.

(a) Blue emitting layer

The blue emitting layer contains a host material and a blue dopant.
The host material is preferably a styryl derivative, an anthracene derivative, or an aromatic amine. The styryl derivative is in particular preferably at least one selected from distyryl derivatives, tristyryl derivatives, tetrastyryl derivatives, and styrylamine derivatives. The anthracene derivative is preferably an asymmetric anthracene compound. The aromatic amine is preferably a compound having 2 to 4 nitrogen atoms which are substituted with an aromatic group, and is in particular preferably a compound having 2 to 4 nitrogen atoms which are substituted with an aromatic group, and having at least one alkenyl group.
The asymmetric anthracene compound preferably includes compounds represented by the following formula. The methods of preparing the above-mentioned compounds are specifically described in Japanese Patent Application No. 2004-042694.
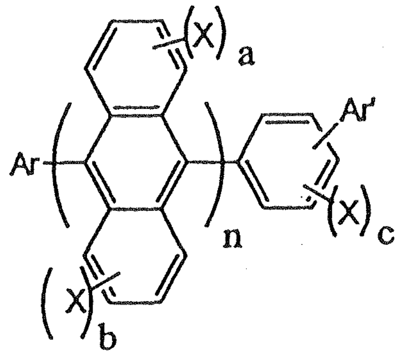

wherein Ar is a substituted or substituted condensed aromatic group having 10 to 50 nucleus carbon atoms,
Ar' is a substituted or unsubstituted aryl group having 6 to 50 nucleus carbon atoms,
X is a substituted or unsubstituted aryl group having 6 to 50 nucleus carbon atoms, substituted or unsubstituted aromatic heterocyclic group having 5 to 50 nucleus carbon atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nucleus atoms, a substituted or unsubstituted arylthio group having 5 to 50 nucleus atoms, a substituted or unsubstituted alkoxycarbonyl group having 1 to 50 carbon atoms, a carboxyl group, a halogen atom, a cyano group, a nitro group or a hydroxyl group.
a, b and c are each an integer of 0 to 4 and n is an integer of 1 to 3.
Examples of the substituted or unsubstituted condensed aromatic group of Ar in the above formula include 1-naphthyl, 2-naphthyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pyrenyl, 2-pyrenyl, 4-pyrenyl, 3-methyl-2-naphthyl, 4-methyl-1-naphthyl, and 4-methyl-1-anthryl groups.
Examples of the substituted or unsubstituted aryl group for Ar', and the aryl, aromatic heterocyclic, alkyl, alkoxy, aralkyl, aryloxy, arylthio and alkoxycarbonyl groups for X in the above formula include the following compounds.
Examples of the substituted or unsubstituted aryl group include phenyl, 1-naphthyl, 2-naphtyl, 1-anthryl, 2-anthryl, 9-anthryl, 1-phenanthryl, 2-phenanthryl, 3-phenanthryl, 4-phenanthryl, 9-phenanthryl, 1-naphthacenyl, 2-naphthacenyl, 9-naphthacenyl, 1-pirenyl, 2-pirenyl, 4-pirenyl, 2-biphenylyl, 3-biphenylyl, 4-biphenylyl, p-terphenyl-4-yl, p-terphenyl-3-yl, p-terphenyl-2-yl, m-terphenyl-4-yl, m-terphenyl-3-yl, m-terphenyl-2-yl, o-tolyl, m-tolyl, p-tolyl, p-t-butylphenyl, p-(2-phenylpropyl)phenyl, 3-methyl-2-naphtyl, 4-methyl-1-naphtyl, 4-methyl-1-anthryl, 4'-methylbiphenylyl and 4"-t-butyl-p-terphenyl-4-yl groups.
Examples of the substituted or unsubstituted aromatic heterocyclic group include 1-pyrrolyl, 2-pyrrolyl, 3-pyrrolyl, pyrazinyl, 2-pyrazinyl, 3-pyrazinyl, 4-pyrazinyl, 1-indolyl, 2-indolyl, 3-indolyl, 4-indolyl, 5-indolyl, 6-indolyl, 7-indolyl, 1-isoindolyl, 2-isoindolyl, 3-isoindolyl, 4-isoindolyl, 5-isoindolyl, 6-isoindolyl, 7-isoindolyl, 2-furyl, 3-furyl, 2-benzofuranyl, 3-benzofuranyl, 4-benzofuranyl, 5-benzofuranyl, 6-benzofuranyl, 7-benzofuranyl, 1-isobenzofuranyl, 3-isobenzofuranyl, 4-isobenzofuranyl, 5-isobenzofuranyl, 6-isobenzofuranyl, 7-isobenzofuranyl, quinolyl, 3-quinolyl, 4-quinolyl, 5-quinolyl, 6-quinolyl, 7-quinolyl, 8-quinolyl, 1-isoquinolyl, 3-isoquinolyl, 4-isoquinolyl, 5-isoquinolyl, 6-isoquinolyl, 7-isoquinolyl, 8-isoquinolyl, 2-quinoxalinyl, 5-quinoxalinyl, 6-quinoxalinyl, 1-carbazolyl, 2-carbazolyl, 3-carbazolyl, 4-carbazolyl, 9-carbazolyl, 1-phenanthrezinyl, 2-phenanthrezinyl, 3-phenanthrezinyl, 4-phenanthrezinyl, 6-phenanthrezinyl, 7-phenanthrezinyl, 8-phenanthrezinyl, 9-phenanthrezinyl, 10-phenanthrezinyl, 1-acridinyl, 2-acridinyl, 3-acridinyl, 4-acridinyl, 9-acridinyl, 1,7-phenanthroline-2-yl, 1,7-phenanthroline-3-yl, 1,7-phenanthroline-4-yl, 1,'7-phenanthroline-5-yl, 1,7-phenanthroline-6-yl, 1,7-phenanthroline-8-yl, 1,7-phenanthroline-9-yl, 1,7-phenanthroline-10-yl, 1,8-phenanthroline-2-yl, 1,8-phenanthroline-3-yl, 1,8-phenanthroline-4-yl, 1,8-phenanthroline-5-yl, 1,8-phenanthroline-6-yl, 1,8-phenanthroline-7-yl, 1,8-phenanthroline-9-yl, 1,8-phenanthroline-10-yl, 1,9-phenanthroline-2-yl, 1,9-phenanthroline-3-yl, 1,9-phenanthroline-4-yl, 1,9-phenanthroline-5-yl, 1,9-phenanthroline-6-yl, 1,9-phenanthroline-7-yl, 1,9-phenanthroline-8-yl, 1,9-phenanthroline-10-yl, 1,10-phenanthroline-2-yl, 1,10-phenanthroline-3-yl, 1,10-phenanthroline-4-yl, 1,10-phenanthraline-5-yl, 2,9-phenanthroline-1-yl, 2,9-phenanthroline-3-yl, 2,9-phenanthroline-4-yl, 2,9-phenanthroline-5-yl, 2,9-phenanthroline-6-yl, 2,9-phenanthroline-7-yl, 2,9-phenanthroline-8-yl, 2,9-phenanthroline-10-yl, 2,8-phenanthroline-1-yl, 2,8-phenanthroline-3-yl, 2,8-phenanthroline-4-yl, 2,8-phenanthroline-5-yl, 2,8-phenanthroline-6-yl, 2,8-phenanthroline-7-yl, 2,8-phenanthroline-9-yl, 2,8-phenanthroline-10-yl, 2,7-phenanthroline-1-yl, 2,7-phenanthroline-3-yl, 2,7-phenanthroline-4-yl, 2,7-phenanthroline-5-yl, 2,7-phenanthroline-6-yl, 2,7-phenanthroline-8-yl, 2,7-phenanthroline-9-yl, 2,7-phenanthroline-10-yl, 1-phenazinyl, 2-phenazinyl, 1-phenothiazinyl, 2-phenothiazinyl, 3-phenothiazinyl, 4-phenothiazinyl, 10-phenothiazinyl, 1-phenoxazinyl, 2-phenoxazinyl, 3-phenoxazinyl, 4-phenoxazinyl, 10-phenoxazinyl, 2-oxazolyl, 4-oxazolyl, 5-oxazolyl, 2-oxadiazolyl, 5-oxadiazolyl, 3-furazanyl, 2-thienyl, 3-thienyl, 2-methylpyrrole-1-yl, 2-methylpyrrole-3-yl, 2-methylpyrrole-4-yl, 2-methylpyrrole-5-yl, 3-methylpyrrole-1-yl, 3-methylpyrrole-2-yl, 3-methylpyrrole-4-yl, 3-methylpyrrole-5-yl, 2-t-butylpyrrole-4-yl, 3-(2-phenylpropyl)pyrrole-1-yl, 2-methyl-1-indolyl, 4-methyl-1-indolyl, 2-methyl-3-indolyl, 4-methyl-3-indolyl, 2-t-butyl1-indolyl, 4-t-butyll-indolyl, 2-t-butyl3-indolyl and 4-t-butyl3-indolyl groups.

Examples of the substituted or unsubstituted alkyl group include methyl, ethyl, propyl, isopropyl, n-butyl, s-butyl, isobutyl, t-butyl, n-pentyl, n-hexyl, n-heptyl, n-octyl, hydroxymethyl, 1-hydroxyethyl, 2-hydroxyethyl, 2-hydroxyisobutyl, 1,2-dihydroxyethyl, 1,3-dihydroxyisopropyl, 2,3-dihydroxy-t-butyl, 1,2,3-trihydroxypropyl, chloromethyl, 1-chloroethyl, 2-chloroethyl, 2-chloroisobutyl, 1,2-dichloroethyl, 1,3-dichloroisopropyl, 2,3-dichloro-t-butyl, 1,2,3-trichloropropyl, bromomethyl, 1-bromoethyl, 2-bromoethyl, 2-bromoisobutyl, 1,2-dibromoethyl, 1,3-dibromoisopropyl, 2,3-dibromo-t-butyl, 1,2,3-tribromopropyl, iodomethyl, 1-iodoethyl, 2-iodoethyl, 2-iodoisobutyl, 1,2-diisodoethyl, 1,3-diiodoisopropyl, 2,3-diiodo-t-butyl, 1,2,3-triiodopropyl, aminomethyl, 1-aminoethyl, 2-aminoethyl, 2-aminoisobutyl, 1,2-diaminoethyl, 1,3-diaminoisopropyl, 2,3-diamino-t-butyl, 1,2,3-triaminapropyl, cyanomethyl, 1-cyanoethyl, 2-cyanoethyl, 2-cyanoisobutyl, 1,2-dicyanoethyl, 1,3-dicyanoisopropyl, 2,3-dicyano-t-butyl, 1,2,3-tricyanopropyl, nitromethyl, 1-nitroethyl, 2-nitroethyl, 2-nitroisobutyl, 1,2-dinitroethyl, 1,3-dinitroisopropyl, 2,3-dinitro-t-butyl, 1,2,3-trinitrapropyl, cyclopropyl, cyclobutyl, cyclopentyl, cyclohexyl, 4-methylcyclohexyl, 1-adamantyl, 2-adamantyl, 1-nobornyl, and 2-nobornyl groups.

The substituted or unsubstituted alkoxy group is represented by -OY. Examples of Y include the same groups as the above-mentioned examples for the substituted or unsubstituted alkyl groups.

Examples of the substituted or unsubstituted aralkyl group include the above-mentioned substituted or unsubstituted aryl groups which are substituted by the above-mentioned substituted or unsubstituted alkyl groups.

The substituted or unsubstituted aryloxy group is represented by -OY'. Examples of Y' include the same groups as the above-mentioned examples for the substituted or unsubstituted aryl groups.

The substituted or unsubstituted arylthio group is represented by -SY'. Examples of Y' include the same groups as the above-mentioned examples for the substituted or unsubstituted aryl groups.

The substituted or unsubstituted alkoxycarbonyl group is represented by -COOY. Examples of Y include the same groups as the above-mentioned examples for the substituted or unsubstituted alkyl groups.

As a halogen atom, fluoride, chlorine, bromine and iodine are given.

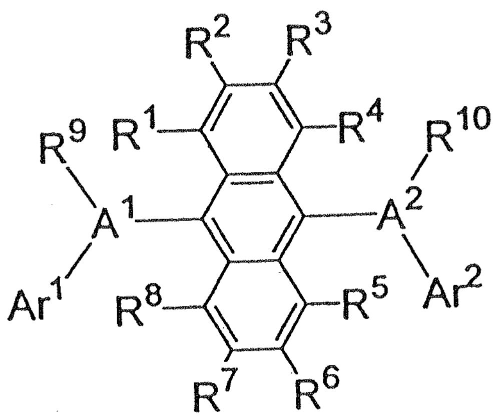

wherein $A^1$ and $A^2$ are independently a substituted or unsubstituted condensed aromatic group having 10 to 20 nucleus carbon atoms,

$Ar^1$ and $Ar^2$ are independently a hydrogen atom or a substituted or unsubstituted aryl group with 6 to 50 nucleus carbon atoms, and

$R^1$ to $R^{10}$ are independently a substituted or unsubstituted aryl group having 6 to 50 nucleus carbon atoms, a substituted or unsubstituted aromatic heterocyclic group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nucleus atoms, a substituted or unsubstituted arylthio group having 5 to 50 nucleus atoms, a substituted or unsubstituted alkoxycarbonyl group having 1 to 50 carbon atoms, a carboxyl group, a halogen atom, a cyano group, a nitro group or a hydroxyl group,

provided that groups do not symmetrically bond to 9 and 10 positions of the central anthracene.

Examples of the substituted or unsubstituted condensed aromatic group for $A^1$ and $A^2$ in the above formula include the same groups mentioned above.

Examples of the substituted or unsubstituted aryl group for $Ar^1$ and $Ar^2$ in the above formula include the same groups mentioned above.

Examples of the substituted or unsubstituted aryl, aromatic heterocyclic, alkyl, alkoxy, aralkyl, aryloxy, arylthio, and alkoxy carbonyl groups for $R^1$ to $R^{10}$ in the above formula include the same groups mentioned above.

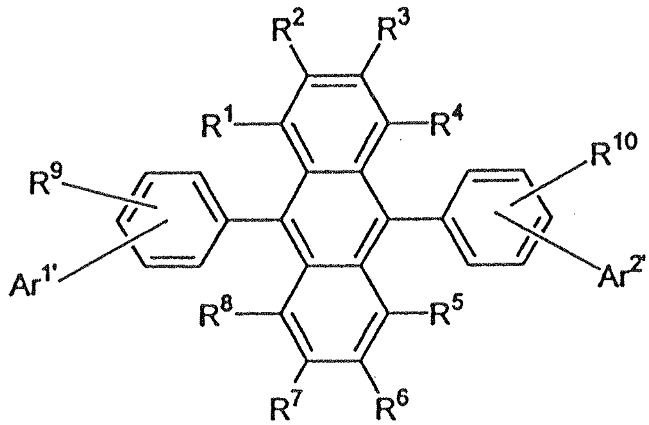

wherein $Ar^{1'}$ and $Ar^{2'}$ are independently a substituted or unsubstituted aryl group having 6 to 50 nucleus carbon atoms, and $R^1$ to $R^{10}$ are independently a substituted or unsubstituted aryl group having 6 to 50 nucleus carbon atoms, a substituted or unsubstituted aromatic heterocyclic group having 5 to 50 nucleus atoms, a substituted or unsubstituted alkyl group having 1 to 50 carbon atoms, a substituted or unsubstituted alkoxy group having 1 to 50 carbon atoms, a substituted or unsubstituted aralkyl group having 6 to 50 carbon atoms, a substituted or unsubstituted aryloxy group having 5 to 50 nucleus atoms, a substituted or unsubstituted arylthio group having 5 to 50 nucleus atoms, a substituted or unsubstituted alkoxycarbonyl group having 1 to 50 carbon atoms, a carboxyl group, a halogen atom, a cyano group, a nitro group or a hydroxyl group.

Examples of the substituted or unsubstituted aryl group of $Ar^{1'}$ and $Ar^{2'}$ in the above formula include the above-mentioned examples.

Examples of the substituted or unsubstituted aryl, aromatic heterocyclic, alkyl, alkoxy, aralkyl, aryloxy, arylthio and alkoxycarbonyl groups for $R^1$ to $R^{10}$ in the above formula include the above-mentioned examples.

Examples of substituents for each of the above groups in the above formulas include halogen atoms, hydroxyl, nitro, cyano, alkyl, aryl, cycloalkyl, alkoxy, aromatic heterocyclic, aralkyl, aryloxy, arylthio, alkoxycarbonyl and carboxyl groups.

The blue dopant is preferably at least one compound selected from styrylamines, amine-substituted styryl compounds, amine-substituted condensed aromatic rings and condensed-aromatic-ring containing compounds. The blue dopant may be composed of plural compounds.

Examples of the styrylamines and amine-substituted styryl compounds are compounds represented by formulas (1) and (2), and examples of condensed-aromatic-ring containing compounds are compounds represented by formula (3).

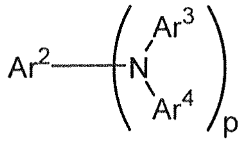

(1)

wherein $Ar^2$, $Ar^3$ and $Ar^4$ are independently a substituted or unsubstituted aromatic group having 6 to 40 carbon atoms and at least one thereof contains a styryl group; and p is an integer of 1 to 3.
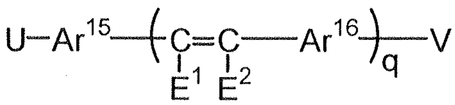

(2)

wherein $Ar^{15}$ and $Ar^{16}$ are independently an arylene group having 6 to 30 carbon atoms, $E^1$ and $E^2$ are independently an aryl or alkyl group having 6 to 30 carbon atoms, a hydrogen atom or a cyano group; q is an integer of 1 to 3; and U and/or V is a substituent containing an amino group and the amino group is preferably an arylamino group.
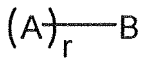

(3)

wherein A is an alkyl or alkoxy group having 1 to 16 carbon atoms, a substituted or unsubstituted aryl group having 6 to 30 carbon atoms, a substituted or unsubstituted alkylamino group having 6 to 30 carbon atoms or a substituted or unsubstituted arylamino group having 6 to 30 carbon atoms; B is a condensed aromatic ring group having 10 to 40 carbon atoms; and r is an integer of 1 to 4.

(5) Green emitting layer

The green emitting layer contains a host material and a green dopant.
It is preferred to use, as the host material, the same host material as used in the blue emitting layer from the viewpoint of reducing color change during continuous lighting.
The dopant is not particularly limited, and, for example, the following can be used: coumalin derivatives disclosed in EP-A-0281381, JP-A-2003-249372, and others; and aromatic amine derivatives wherein a substituted anthracene structure and an amine structure are linked to each other.

(6) Orange-to-red emitting layer

An orange-to-red emitting layer contains a host material and an orange-to-red dopant.
It is preferred to use, as the host material, the same host material as used in the blue emitting layer from the viewpoint of reducing color change during continuous lighting.
As the dopant, there can be used a fluorescent compound having at least one fluoranthene skeleton or perylene skeleton, for example, compounds represented by the following formula (4):
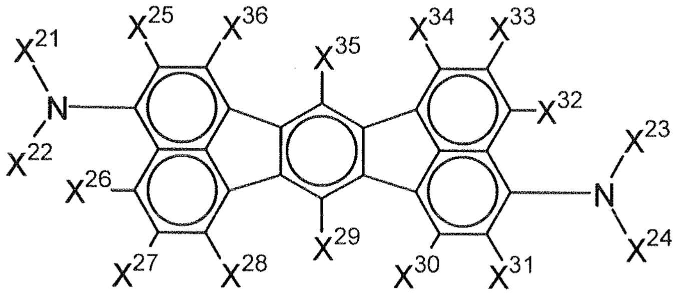

(4)

wherein $X^{21}$ to $X^{24}$ are independently an alkyl group having 1 to 20 carbon atoms or a substituted or unsubstituted aryl group having 6 to 30 carbon atoms; $X^{21}$ and $X^{22}$ and/or $X^{23}$ and $X^{24}$ may be bonded via a carbon-carbon bond, -O- or -S-; $X^{25}$ to $X^{36}$ are a hydrogen atom, a linear, branched or cyclic alkyl group having 1 to 20 carbon atoms, a linear, branched or cyclic alkoxy group having 1 to 20 carbon atoms, a substituted or unsubstituted aryl group having 6 to 30 carbon atoms, a substituted or unsubstituted aryloxy group having 6 to 30 carbon atoms, a substituted or unsubstituted arylamino group having 6 to 30 carbon atoms, a substituted or unsubstituted alkylamino group having 1 to 30 carbon atoms, a substituted or unsubstituted arylalkylamino group having 7 to 30 carbon atoms or a substituted or unsubstituted alkenyl group having 8 to 30 carbon atoms; adjacent substituents and $X^{25}$ to $X^{36}$ may be bonded to form a cyclic structure; and at least one of the substituents $X^{25}$ to $X^{36}$ in each of the formulas preferably contain an amine or alkenyl group.

(7) Hole-transporting layer

In the invention, a hole-transporting layer may be provided between the organic electroluminescent medium layer and the hole-injecting layer.
Such a hole-transporting layer is preferably made of a material which can transport holes to the emitting layer at lower electric field intensity. The hole mobility thereof is preferably at least $10^{-4}$ $cm^2/V\cdot$second when an electric field of $10^4$ to $10^6$ V/cm is applied.

The material for forming the hole-transporting layer can be arbitrarily selected from materials which have been widely used as a hole-transporting material in photoconductive materials and known materials used in a hole-transporting layer of organic EL elements.

Specific examples thereof include triazole derivatives (see USP No. 3,112,197 and others), oxadiazole derivatives (see USP No. 3,189,447 and others), imidazole derivatives (see JP-B-37-16096 and others), polyarylalkane derivatives (see USP Nos. 3,615,402, 3,820,989 and 3,542,544, JP-B-45-555 and 51-10983, JP-A-51-93224, 55-17105, 56-4148, 55-108667, 55-156953 and 56-36656, and others), pyrazoline derivatives and pyrazolone derivatives (see USP Nos. 3,180,729 and 4,278,746, JP-A-55-88064, 55-88065, 49-105537, 55-51086, 56-80051, 56-88141, 57-45545, 54-112637 and 55-74546, and others), phenylene diamine derivatives (see USP No. 3,615,404, JP-B-51-10105, 46-3712 and 47-25336, JP-A-54-53435, 54-110536 and 54-119925, and others), arylamine derivatives (see USP Nos. 3,567,450, 3,180,703, 3,240,597, 3,658,520, 4,232,103, 4,175,961 and 4,012,376, JP-B-49-35702 and 39-27577, JP-A-55-144250, 56-119132 and 56-22437, DE1, 110, 518, and others), amino-substituted chalcone derivatives (see USP No. 3,526,501, and others), oxazole derivatives (ones disclosed in USP No. 3,257,203, and others), styrylanthracene derivatives (see JP-A-56-46234, and others), fluorenone derivatives (JP-A-54-110837, and others), hydrazone derivatives (see USP Nos. 3,717,462, JP-A-54-59143, 55-52063, 55-52064, 55-46760, 55-85495, 57-11350, 57-148749 and 2-311591, and others), stilbene derivatives (see JP-A-61-210363, 61-228451, 61-14642, 61-72255, 62-47646, 62-36674, 62-10652, 62-30255, 60-93455, 60-94462, 60-174749 and 60-175052, and others), silazane derivatives (USP No. 4,950,950), polysilanes (JP-A-2-204996), aniline copolymers (JP-A-2-282263), and electroconductive oligomers (in particular thiophene oligomers) disclosed in JP-A-1-211399.

The hole-transporting layer can be formed from the above compounds by known methods such as vacuum deposition, spin coating, casting and LB technique.
The thickness of the hole-transporting layer is not particularly limited but is preferably 5 nm to 5 μm, particularly preferably 5 to 40 nm. The hole-transporting layer may be a single layer made of one kind or two or more kinds of the above-mentioned materials. The hole-transporting layer may be stacked layer made of different compounds.

(8) Hole-injecting layer

The same material for forming the hole-transporting layer can be used as the material of the hole-injecting layer. The following are preferably used: porphyrin compounds (disclosed in JP-A-63-2956965 and others), aromatic

tertiary amine compounds and styrylamine compounds (see USP No. 4,127,412, JP-A-53-27033, 54-58445, 54-149634, 54-64299, 55-79450, 55-144250, 56-119132, 61-295558, 61-98353 and 63-295695, and others), in particular, the aromatic tertiary amine compounds.

The following can also be given as examples: 4,4'-bis (N-(1-naphthyl)-N-phenylamino) biphenyl (hereinafter abbreviated to NPD), which has in the molecule thereof two condensed aromatic rings, disclosed in USP No. 5,061,569, and 4,4',4"-tris(N-(3-methylphenyl)-N-phenylamino)triphenylamine (hereinafter abbreviated to MTDATA), wherein three triphenylamine units are linked to each other in a star-burst form, disclosed in JP-A-4-308688.

In addition to aromatic dimethylidene type compounds, inorganic compounds such as p-type Si and p-type SiC can also be used as the material of the hole-injecting layer. The organic semiconductor layer is one type of the hole-injecting layer, is a layer for helping the injection of holes or electrons into the emitting layer, and is preferably a layer having an electroconductivity of $10^{-10}$ S/cm or more. The material of such an organic semiconductor layer may be an electroconductive oligomer, such as thiophene-containing oligomer or arylamine-containing oligomer disclosed in JP-A-8-193191, an electroconductive dendrimer such as arylamine-containing dendrimer.

The hole-injecting layer can be formed from the above compounds by known methods such as vacuum deposition, spin coating, casting and LB technique.

The hole-injecting layer may be a single layer made of one kind or two or more kinds of the above-mentioned materials. Alternatively, the hole-injecting layer may be formed by stacking hole-injecting layers made of different compounds.

(9) Electron-transporting layer

In the invention, an electron-transporting layer may be provided between the cathode and the organic electroluminescent medium layer.

The thickness of electron-transporting layer is properly selected several nm to several μm but is preferably selected such that the electron mobility is $10^{-5}$ $cm^2$/Vs or more when applied with an electric field of $10^4$ to $10^6$ V/cm.

The material used in the electron-transporting layer is preferably a metal complex of 8-hydroxyquinoline or a derivative thereof.

Specific examples of the above-mentioned metal complex of 8-hydroxyquinoline or derivative thereof include metal chelate oxynoid compounds containing a chelate of oxine (generally, 8-quinolinol or 8-hydroxyquinoline).

For example, Alq as described in the explanation of the emitting material can be used for the electron-injecting layer.

Examples of the oxadiazole derivative include electron-transferring compounds represented by the following general formulas.

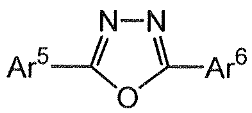

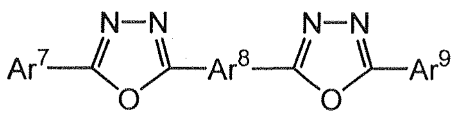

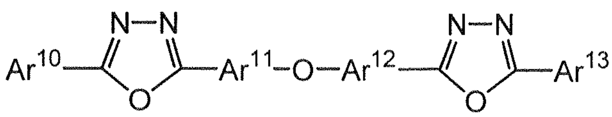

wherein $Ar^5$, $Ar^6$, $Ar^7$, $Ar^9$, $Ar^{10}$ and $Ar^{13}$ each represent a substituted or unsubstituted aryl group and may be the same or different, and $Ar^8$, $Ar^{11}$ and $Ar^{12}$ represent a substituted or unsubstituted arylene group and may be the same or different.

Examples of the aryl group include phenyl, biphenyl, anthranyl, perylenyl, and pyrenyl groups. Examples of the arylene group include phenylene, naphthylene, biphenylene, anthranylene, perylenylene, and pyrenylene groups. Examples of the substituent include alkyl groups with 1 to 10 carbon atoms, alkoxy groups with 1 to 10 carbon atoms, and a cyano group. The electron-transferring compounds are preferably ones from which a thin film can be formed.

Specific examples of the electron-transferring compounds include the following.

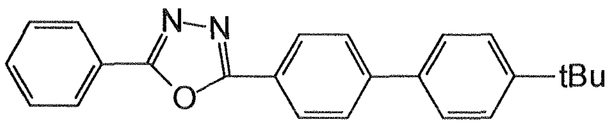

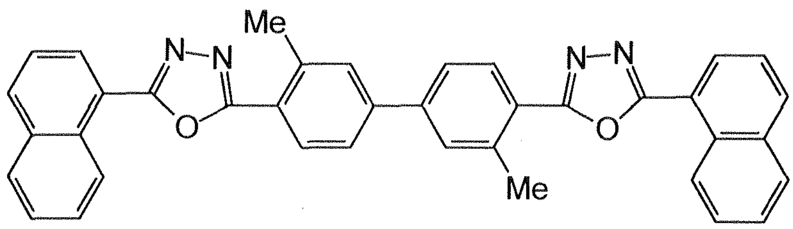

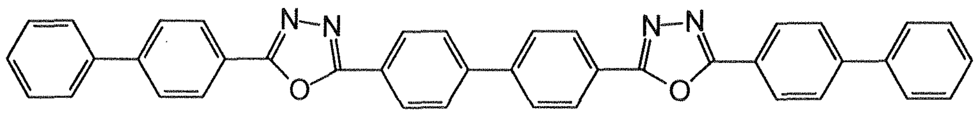

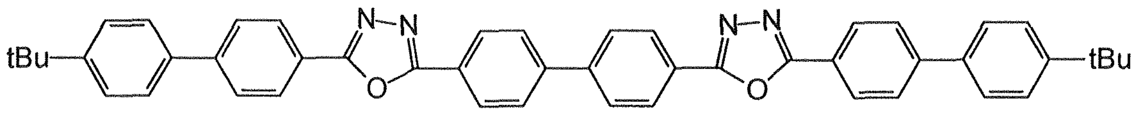

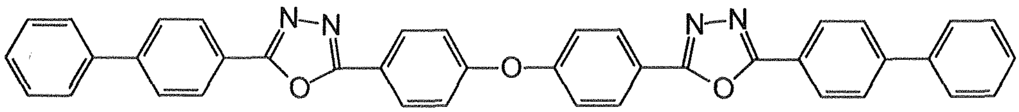

wherein Me is methyl and tBu is t-butyl.

Nitrogen-containing heterocyclic derivatives represented by the following formula:

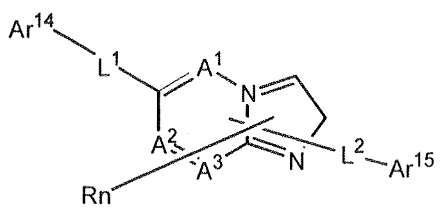

wherein $A^1$ to $A^3$ are a nitrogen atom or a carbon atom;

R is an aryl group having 6 to 60 carbon atoms which may have a substituent, a heteroaryl group having 3 to 60 carbon atoms which may have a substituent, an alkyl group having 1 to 20 carbon atoms, a haloalkyl group having 1 to 20 carbon atoms or an alkoxy group having 1 to 20 carbon atoms; n is an integer of 0 to 5; when n is an integer of 2 or more, Rs may be the same or different;

adjacent Rs may be bonded to each other to form a substituted or unsubstituted carbon aliphatic ring or a substituted or unsubstituted carbon aromatic ring;

$Ar^{14}$ is a substituted or unsubstituted aryl group having 6 to 60 carbon atoms or a substituted or unsubstituted heteroaryl group having 3 to 60 carbon atoms;

$Ar^{15}$ is a hydrogen atom, an alkyl group having 1 to 20 carbon atoms, a haloalkyl group having 1 to 20 carbon atoms, an alkoxy group having 1 to 20 carbon atoms, an aryl group having 6 to 60 carbon atoms which may have a substituent or a heteroaryl group having 3 to 60 carbon atoms which may have a substituent;
provided that one of $Ar^{14}$ and $Ar^{15}$ is a substituted or unsubstituted condensed ring having 10 to 60 carbon atoms or a substituted or unsubstituted hetero condensed ring having 3 to 60 carbon atoms;
$L^1$ and $L^2$ are independently a single bond, a substituted or unsubstituted condensed ring having 6 to 60 carbon atoms, a substituted or unsubstituted hetero condensed ring having 3 to 60 carbon atoms or a substituted or unsubstituted fluorenylene group.

Nitrogen-containing heterocyclic derivatives represented by the following formula:

$$HAr-L^3-Ar^{16}-Ar^{17}$$

wherein HAr is a nitrogen-containing heterocyclic ring with 3 to 40 carbon atoms which may have a substituent;
$L^3$ is a single bond, an arylane group with 6 to 60 carbon atoms which may have a substituent, a heteroarylane group with 3 to 60 carbon atoms which may have a substituent or a fluorenylene group which may have a substituent;
$Ar^{16}$ is a bivalent aromatic hydrocarbon group with 6 to 60 carbon atoms which may have a substituent; and
$Ar^{17}$ is an aryl group with 6 to 60 carbon atoms which may have a substituent or a heteroaryl group with 3 to 60 carbon atoms which may have a substituent.

(10) Electron-injecting layer

In the invention, an electron-injecting layer which is formed of an insulator or a semiconductor may be provided between a cathode and an electron-injecting layer or between a cathode and an emitting layer. By providing such an electron-injecting layer, current leakage can be effectively prevented to improve the injection of electrons.
As the insulator, a single metal compound or a combination of metal compounds selected from alkali metal calcogenides, alkaline earth metal calcogenides, halides of alkali metals, halides of alkaline earth metals, aluminum oxide, aluminum nitride, titanium oxide, silicon oxide, germanium oxide, silicon nitride, boron nitride, molybdenum oxide, ruthenium oxide and vanadium oxide can be preferably used. Among these metal compounds, the alkali metal calcogenides or alkaline earth metal calcogenides are preferred in view of the injection of electrons.
Preferable alkali metal calcogenides include $Li_2O$, LiO, $Na_2S$, $Na_2Se$ and NaO. Preferable alkaline earth metal calcogenides include CaO, BaO, SrO, BeO, BaS and CaSe. Preferable halides of alkali metals include LiF, NaF, KF, LiCl, KCl and NaCl. Preferable halides of alkaline earth metals include fluorides such as $CaF_2$, $BaF_2$, $SrF_2$, $MgF_2$ and $BeF_2$ and their halides other than fluorides.

Examples of the semiconductor for forming the electron-injecting layer include oxides, nitrides or oxynitrides containing at least one element selected from Ba, Ca, Sr, Yb, Al, Ga, In, Li, Na, Cd, Mg, Si, Ta, Sb and Zn, and combinations of two or more thereof.

The electron-transporting layer is preferably a microcrystalline or amorphous. Because a more uniform thin film can be formed to reduce pixel defects such as dark spots.
Two or more electron-injecting layers may be stacked.

The film thickness of each of the organic layers forming an emitting layer is not particularly limited. In general, defects such as pinholes are easily generated when the film thickness is too small. Conversely, a high applied voltage becomes necessary, leading to worse efficiency when the film thickness is too large. Usually, therefore, the film thickness is preferably in the range of several nanometers to one micrometer.

(11) Metal layer/second reflecting member

As the material for the second reflecting member, it is preferable to use a metal which reflects and transmits light emitted from the organic luminescent medium layer and can form an optical resonator with the above-mentioned reflecting electrode. As examples of such a metal, metals such as Ag, Mg, Al, Au, Pt, Cu, Cr, Mo, W, Ta, Nb, Li, Mn, Ca, Yb, Ti, Ir, Be, Hf, Eu, Sr, Ba, Cs, Na, and K, and an alloy of these metals can be given. When using the metal layer as a cathode contacting the organic luminescent medium, Al, Ag, Mg, Ce, Na, K, Cs, and Li, and an alloy of these metals are preferable due to a small work function (e.g. 4.0 eV or less). The thickness of the metal layer is preferably 2 nm to 100 nm. If the thickness is less than 2 nm, the electron-injecting properties are decreased when used as a cathode, whereby the luminous efficiency of the device may be decreased, or a sufficient optical resonator effect cannot be obtained due to high transmittance. In addition, the organic luminescent medium layer positioned under the metal layer may be damaged when forming the transparent electrode layer by sputtering or the like. If the thickness is larger than 100 nm, the light-outcoupling efficiency may be decreased due to a decrease in transmittance.

As the material for the transparent electrode, ITO, IZO, tin oxide, zinc oxide and so on can be given. The

electrode preferably has a transmittance of 30% or more for outputting emission.

(12) Color filter

Examples of materials for the color filter used in the invention include dyes only or solid objects in which a dye is dissolved or dispersed in a binder resin.
Red dye (R): perylene pigment, lake pigment, azo pigment and the like
Green dye (G): halogen-multisubstituted phthalocyanine pigment, halogen-multisubstituted copper phthalocyanine pigment, basic triphenylmethane dye and the like
Blue dye (B): copper phthalocyanine pigment, indanthrone pigment, indophenol pigment, cyanine pigment and the like.
On the other hand, material for the binder resin is preferably transparent (transmittance of visible light: 50% or more). Examples of the binder resin include transparent resins (polymers) such as polymethyl methacrylate, polyacrylate, polycarbonate, polyvinyl alcohol, polyvinyl pyrrolidone, hydroxyethylcellulose, and carboxymethylcellulose, and photosetting resist materials having reactive vinyl groups such as acrylic acid type, methacrylic acid type, and the like, as photosensitive resins to which photolithography can be applied.
When employing a printing method, a print ink (medium) including a transparent resin such as polyvinyl chloride resin, melamine resin, or phenol resin may be selected.
When forming the color filter using a dye as the major component, the color filter may be formed by a vacuum deposition method or a sputtering method using a mask having a desired color filter pattern.
When forming the color filter using a dye and a binder resin, the dye, the above-mentioned resin and a resist are mixed, dispersed, or dissolved to prepare a fluid. The fluid is applied by spin coating, roll coating, casting, or the like. The resulting film is generally patterned into a desired color filter pattern by a photolithography or printing.
The thickness and the transmittance of each color filter are preferably set as follows.

R: thickness: 0.5 to 5.0 μm (transmittance: 50% or more at 610 nm)
G: thickness: 0.5 to 5.0 μm (transmittance: 50% or more at 545 nm)
B: thickness: 0.2 to 5.0 μm (transmittance: 50% or more at 460 nm)

In the invention, when providing a full-color display which emits light of red, green, and blue (three primary colors), a black matrix may be used to increase the contrast ratio.

EXAMPLES

Example:

1. Fabrication of organic EL device substrate (Formation of reflecting electrode and optical thickness adjustment layer)

An aluminum film with a thickness of 300 nm was formed by sputtering on a supporting substrate with a size of 150 mm x 150 mm x 1.1 mm (OA2 glass manufactured by Nippon Electric Glass Co., Ltd.). A positive type resist (HPR204 manufactured by Fujifilm Olin Co., Ltd.) was formed on the aluminum film by spin coating. The resist film was exposed to ultraviolet rays through a photomask for forming a striped pattern with a line width of 20 μm. The resist film was developed using a tetramethylammonium hydroxide (TMAH) developer and baked at 130°C. The exposed aluminum layer was etched using an aluminum etchant (phosphoric acid/nitric acid/acetic acid solution). The resist film was treated with a stripper containing ethanolamine as the main component (N303 manufactured by Nagase & Company, Ltd.) to form a lower electrode with a width of 80 μm and a gap of 20 μm.
An indium oxide-cerium oxide (ICO) film with a thickness of 20 nm was formed on the lower electrode by sputtering. A positive type resist (HPR204 manufactured by Fujifilm Olin Co., Ltd.) was formed on the ICO film by spin coating. The resist film was exposed to ultraviolet rays through a photomask for forming a striped pattern with a line width of 20 μm while aligning the mask with the striped pattern of the lower electrode. The resist film was developed using a tetramethylammonium hydroxide (TMAH) developer and baked at 130°C. The exposed ICO was etched using an ICO etchant (47% hydrobromic acid) to form an ICO layer with a pattern in which a portion with a width of 80 μm, a gap of 20 μm, a portion with a width of 80 μm, and a gap of 120 μm were periodically repeated.
The substrate was heated using a furnace at 230°C for 30 minutes to crystallize the ICO. An IZO(indium oxide with a zinc oxide content of 10 wt%) film with a thickness of 20 nm was formed on the ICO layer by sputtering. A positive type resist (HPR204: manufactured by Fujifilm Olin Co., Ltd.) was formed on the IZO film by spin coating. The resist film was exposed to ultraviolet rays through a photomask for forming a striped pattern with a line width of 20 μm while aligning the mask with the striped pattern of the lower electrode. The resist film was developed using a tetramethylammonium hydroxide (TMAH) developer and baked at 130°C. The exposed IZO was etched using an IZO etchant (3.5% oxalic acid

aqueous solution) to form an IZO layer with a pattern in which a portion with a width of 80 μm and a gap of 220 μm were periodically repeated.

As an inter-insulator, a negative-type resist (V259BK manufactured by Nippon Steel Chemical Co., Ltd.) was applied by spin coating, irradiated with ultraviolet rays, and developed using a tetramethylammonium hydroxide (TMAH) developer. The resist was baked at 200°C to form an organic inter-insulator covering the edge of the aluminum lower electrode (aperture area was 70 μm x 270 μm).

The reflectance of the aluminum-exposing part for perpendicularly incident light in the perpendicular direction was measured using a microspectroscopic reflectometer. The average reflectance in a wavelength range of 400 nm to 700 nm was 91.8% exceeding 65%. The measured reflectance is shown in Fig. 4.

(Formation of three wavelength type organic EL emitting part)

The above substrate was subjected to ultrasonic cleaning in isopropyl alcohol for 5 minutes, and then cleaned with ultraviolet ozone for 30 minutes. The cleaned substrate with an under electrode was installed in a substrate holder of a vacuum deposition apparatus. The following compound (HI)(hereinafter HI film) as a hole-injecting material, the following compound (HT)(hereinafter HT film) as a hole-transporting material, the following compound (BH) as a host of an emitting material, the following compound (BD) as a blue emitting dopant, the following compound (GD) as a green emitting dopant, the following compound (RD) as a red emitting dopant, a tris(8-quinolinol)aluminum (Alq) as an electron-transporting material, LiF as an electron-injecting material, and Mg and Ag as a cathode material were charged in advance in individual molybdenum heating boats. As a hole injecting supporting material and a leading electrode of a cathode, an IZO target was installed in another sputtering vessel.

First, IZO was deposited in a thickness of 1 nm by sputtering as a hole injecting supporting layer so as to cover the substrate. Next, an HI film functioning as a hole-injecting layer was deposited in a thickness of 25 nm. Following the HI film formation, an HT film functioning as a hole-transporting layer was deposited in a thickness of 10 nm. After forming the HT film, as a blue emitting layer, the compound BH and compound BD were co-deposited in a thickness of 10 nm at a thickness ratio of 10:0.5. Next, as a green emitting layer, the compound BH and compound GD were co-deposited in a thickness of 10 nm at a thickness ratio of 10:0.8. Further, as a red emitting layer, the compound BH and compound RD were co-deposited in a thickness of 20 nm at a thickness ratio of 20:0.5.

On the film, as an electron-transporting layer, an Alq film was deposited in a thickness of 10 nm. As an electron-injecting layer, LiF was deposited in a thickness of 1 nm, and as a cathode (metal layer), Ag and Mg was deposited thereon in a thickness of 10 nm at a film-formation rate ratio of 1:9. Further, as a transparent upper electrode, an IZO film was formed by sputtering in a thickness of 90 nm.

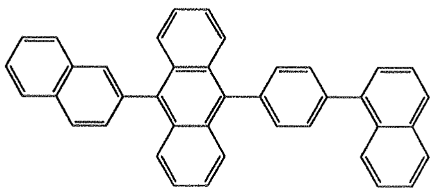

BH

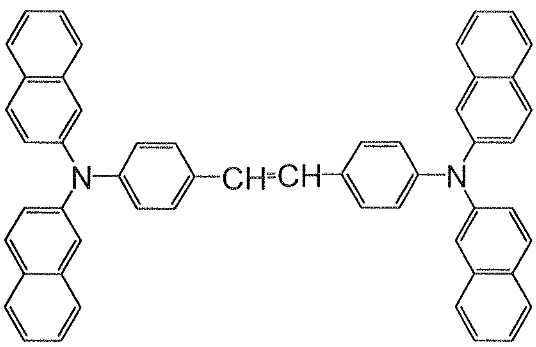

BD

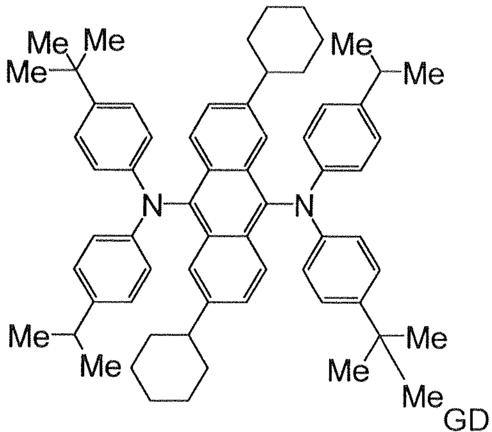

GD

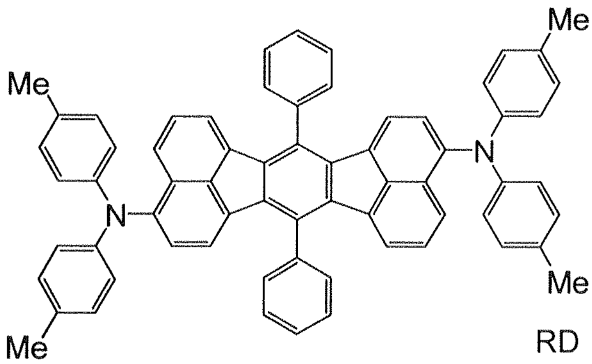

RD

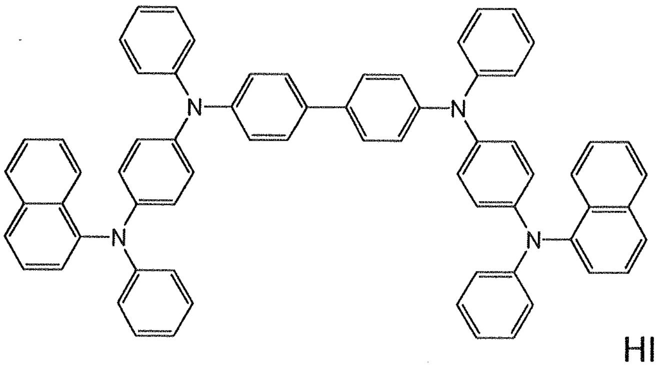

HI

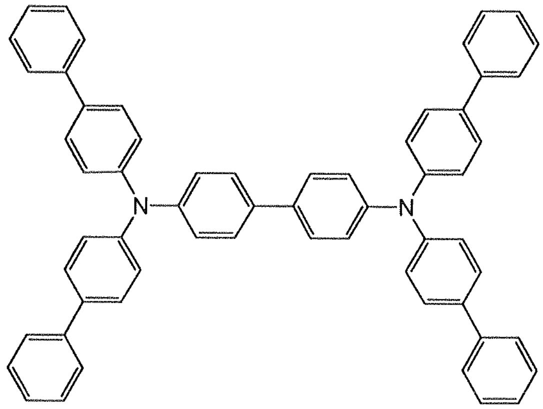

HT

(Formation of solid sealing film)

Next, on the upper electrode of the organic EL device, as a transparent inorganic film, a SiOxNy (O/O+N=50%: Atomic ratio) film was formed in a thickness of 300 nm by low temperature CVD so as to cover the entire organic EL emitting part as a sealing layer.

2. Fabrication of color filter substrate

(Formation of shielding layer)

A shielding layer pattern was formed on a supporting substrate having dimensions of 112 mm x 143 mm x 1.1 mm (OA2 glass: Nippon Electric Glass Co., Ltd.). As a shielding layer, a 50 nm thick chrome oxide film and a 300 nm thick chrome film were sequentially stacked by sputtering.

Next, on the shielding layer, a positive-type resist ("HPR204" manufactured by Fujifilm Olin Co., Ltd.) film was formed by spin coating. Subsequently, the resist film was exposed to ultraviolet rays through a photomask. The film was then developed using a TMAH (tetramethylammonium hydroxide) developer and baked at 130°C. The exposed chrome layer and chrome oxide layer were etched using a chrome etchant of a ceric ammonium nitrate/perchloric acid aqueous solution. Subsequently, the resist was removed with a stripper containing ethanolamine as the major component ("N303" manufactured by Nagase & Co., Ltd.) to obtain a lattice-shaped shielding layer pattern with a width of 30 μm and an opening of 70 μm x 270 μm.

(Formation of color filter layer)

V259 (manufactured by Nippon Steel Chemical Co., Ltd.) as a material for a blue (B) filter layer pattern was applied by spin coating on a supporting substrate to form a film. Ultraviolet rays were applied through a photomask aligned with the shielding layer so as to obtain 76,800 dot patterns of stripe-like color arrangement (rectangular: 90 μm x 290 μm). The resultant film was then developed using a 2% sodium carbonate aqueous solution and baked at 200°C to obtain a blue color filter layer pattern (thickness: 1.5 μm).

Next, a pigment-type green color filter material (CG-8510L, manufactured by FUJIFILM Arch Co., Ltd.) as a material for a green (G) color filter layer pattern was applied by spin coating to form a film. Ultraviolet rays were applied through the photomask used for the blue color filter layer pattern displaced at 100 μm pitch from the blue color filter layer pattern in the perpendicular direction to the stripe-like color arrangement. The film was then baked at 200°C to obtain a green color filter layer pattern (thickness: 1.0 μm).

Next, a pigment-type red color filter material (CRY-S840B, manufactured by FUJIFILM Arch Co., Ltd.) as a material for a red (R) color filter layer pattern was applied by spin coating to form a film. Ultraviolet rays were applied through the photomask used for the blue color filter layer pattern displaced at 200 μm pitch from the blue color filter layer pattern in the perpendicular direction to the stripe-like color arrangement. The film was then baked at 200°C to obtain a red color filter layer pattern (thickness: 1.2 μm).

3. Adhesion of organic EL device substrate to color filter substrate

A liquid silicone rubber (XE14-128, manufactured by Toshiba Silicone Co. Ltd.) was applied on the color filter substrate using a spin-coater. The above organic EL device substrate was adhered thereto matching a positioning mark

4. Evaluation of organic EL display

(Blue performance)

When applying a direct-current voltage of 7.2 V between the lower electrode and the upper transparent electrode corresponding to the blue color filter, blue light was obtained. The luminance and the chromaticity were measured using a spectroradiometer CS-1000 (manufactured by Minolta) and found to be 45 nit and (0.135, 0.078), respectively. The current flowing between the electrodes was measured, and the luminous efficiency was calculated. The luminous efficiency was 1.78 cd/A.

(Green performance)

When applying a direct-current voltage of 7.2 V between the lower electrode and the upper transparent electrode corresponding to the green color filter, green light was obtained. The luminance and the chromaticity were measured using a spectroradiometer CS-1000 (manufactured by Minolta) and found to be 331 nit and (0.224, 0.639), respectively. The current flowing between the electrodes was measured, and the luminous efficiency was calculated. The luminous efficiency was 13.2 cd/A.

(Red performance)

When applying a direct-current voltage of 7.2 V between the lower electrode and the upper transparent electrode corresponding to the red color filter, red light was obtained. The luminance and the chromaticity were measured using a spectroradiometer CS-1000 (manufactured by Minolta) and found to be 83 nit and (0.629, 0.370), respectively. The current flowing between the electrodes was measured, and the luminous efficiency was calculated. The luminous efficiency was 3.34 cd/A.

(Full-screen operation)

When applying a direct-current voltage of 7.2 V between all the lower electrodes and the upper transparent electrode, white light was obtained. The luminance and the chromaticity were measured using a spectroradiometer CS-1000 (manufactured by Minolta) and found to be 459 nit and (0.255, 0.350), respectively. The current flowing between the electrodes was measured, and the luminous efficiency was calculated. The luminous efficiency was as high as 6.11 cd/A. Although the reflectance (91%) in this example was 1.6 times the reflectance in the comparative example described later using Cr as the lower electrode, the efficiency obtained in this example was four times the efficiency obtained in the comparative example. The National Television Standards Committee (NTSC) ratio calculated from the blue chromaticity, the green chromaticity, and the red chromaticity was as high as 79.3%.

(Evaluation of contrast ratio)

The screen luminance during the non-operation state when illuminated to 1000 lux using a fluorescent lamp was measured and found to be 5.8 nit. The contrast ratio calculated from the luminance (459 nit) during the full-screen operation and the luminance (5.8 nit) during the non-operation state was 79. A practical contrast was unexpectedly obtained although the highly reflective lower electrode was used.

Comparative Example:

An organic EL display having a configuration similar to that of the example was fabricated except for using chromium as the material for the lower electrode instead of aluminum. As a chromium etchant used when forming an electrode pattern, a ceric ammonium nitrate/perchloric acid aqueous solution (HCE manufactured by Nagase & Company, Ltd.) was used.
The reflectance of the chromium-exposing portion was exposed was measured using a microspectroscope. The average reflectance at a wavelength of 400 nm to 700 nm was 56%, which is smaller than 65%. FIG. 4 shows the measured reflectance.

When applying a direct-current voltage of 7.2 V between the lower electrode and the upper transparent electrode corresponding to the blue color filter, blue light was obtained. The luminance and the chromaticity were measured using a spectroradiometer CS-1000 (manufactured by Minolta) and found to be 19 nit and (0.134, 0.090), respectively. The current flowing between the electrodes was measured, and the luminous efficiency was calculated. The luminous efficiency was 0.76 cd/A.

(Green performance)

When applying a direct-current voltage of 7.2 V between the lower electrode and the upper transparent electrode corresponding to the green color filter, green light was obtained. The luminance and the chromaticity were measured using a spectroradiometer CS-1000 (manufactured by Minolta) and found to be 135 nit and (0.236, 0.612), respectively. The current flowing between the electrodes was measured, and the luminous efficiency was calculated. The luminous efficiency was 5.41 cd/A.

(Red performance)

When applying a direct-current voltage of 7.2 V between the lower electrode and the upper transparent electrode corresponding to the red color filter, red light was obtained. The luminance and the chromaticity were measured using a spectroradiometer CS-1000 (manufactured by Minolta) and found to be 38 nit and (0.630, 0.368), respectively. The current flowing between the electrodes was measured, and the luminous efficiency was calculated. The luminous efficiency was 1.51 cd/A.

(Full-screen operation)

When applying a direct-current voltage of 7.2 V between all the lower electrodes and the upper transparent electrode, white light was obtained. The luminance and the chromaticity were measured using a spectroradiometer CS-1000 (manufactured by Minolta) and found to be 192 nit and (0.271, 0.359), respectively. The current flowing between the electrodes was measured, and the luminous efficiency was calculated. The luminous efficiency was 2.56 cd/A, which is less than half the luminous efficiency of the example. The NTSC ratio was 72.9%, which is lower than that of the example.

(Evaluation of contrast ratio)

The screen luminance during the non-operation state when illuminated to 1000 lux using a fluorescent lamp was measured and found to be 1.4 nit. The contrast ratio calculated from the luminance (192 nit) during the full-screen operation and the luminance (1.4 nit) during the non-operation state was 138.

The table and FIGS. 5 to 8 show the evaluation results of the example and the comparative example. FIG. 5 is a view showing the blue pixel emission spectra of the example (Al electrode) and the comparative example (Cr electrode).

FIG. 6 is a view showing the green pixel emission spectra of the example (Al electrode) and the comparative example (Cr electrode). FIG. 7 is a view showing the red pixel emission spectra of the example (Al electrode) and the comparative example (Cr electrode).

INDUSTRIAL APPLICABILITY

The organic EL display according to the invention may be used for various displays such as consumer televisions, large displays, and displays for portable telephones.

## Claims

1. An organic electroluminescent display comprising:

    a first pixel comprising a first organic electroluminescent device and a first color filter which transmits light of a first color emitted from the first organic electroluminescent device, provided in that order in a light-outcoupling direction;

    a second pixel comprising a second organic electroluminescent device and a second color filter which transmits light of a second color emitted from the second organic electroluminescent device, provided in that order in the light-outcoupling direction; and

a third pixel comprising a third organic electroluminescent device and a third color filter which transmits light of a third color emitted from the third organic electroluminescent device, provided in that order in the light-outcoupling direction;

the first organic electroluminescent device comprising at least a first reflecting member and a second reflecting member in that order in the light-outcoupling direction, and an organic luminescent medium layer provided between the first and second reflecting members, an optical distance between the first and second reflecting members being set to select light of the first color;

the second organic electroluminescent device comprising at least a first reflecting member and a second reflecting member in that order in the light-outcoupling direction, and the organic luminescent medium layer provided between the first and second members, an optical distance between the first and second reflecting members being set to select light of the second color;

the third organic electroluminescent device comprising at least a first reflecting member and a second reflecting member in that order in the light-outcoupling direction, and the organic luminescent medium layer provided between the first and second reflecting members, an optical distance between the first and second reflecting members being set to select light of the third color;

the first reflecting member having an average reflectance of 65% or more for light having a wavelength of 400 nm to 700 nm; and

the organic luminescent medium layer emitting light of at least the first color, the second color and the third color.

**2.** The organic electroluminescent display according to claim 1 wherein the first reflecting member and the second reflecting member are a first electrode and a second electrode, respectively, or a first electrode and a second electrode are provided between the first reflecting member and the second reflecting member; and
the organic luminescent medium layer is positioned between the first electrode and the second electrode.

**3.** An organic electroluminescent display comprising:

a first pixel comprising a first organic electroluminescent device and a first color filter which transmits light of a first color emitted from the first organic electroluminescent device, provided in that order in a light-outcoupling direction;

a second pixel comprising a second organic electroluminescent device and a second color filter which transmits light of a second color emitted from the second organic electroluminescent device, provided in that order in the light-outcoupling direction; and

a third pixel comprising a third organic electroluminescent device and a third color filter which transmits light of a third color emitted from the third organic electroluminescent device, provided in that order in the light-outcoupling direction;

the first organic electroluminescent device sequentially comprising at least a reflecting electrode, organic luminescent medium layer, metal layer and transparent electrode layer in the light-outcoupling direction,

the second organic electroluminescent device sequentially comprising at least a reflecting electrode, first optical thickness adjustment layer, organic luminescent medium layer, metal layer and transparent electrode layer in the light-outcoupling direction,

the third organic electroluminescent device sequentially comprising at least a reflecting electrode, second optical thickness adjustment layer, organic luminescent medium layer, metal layer and transparent electrode layer in the light-outcoupling direction,

the reflecting electrode having an average reflectance of 65% or more for light having a wavelength of 400 nm to 700 nm; and

the organic luminescent medium layer emitting light of at least the first color, the second color and the third color.

**4.** The organic electroluminescent display according to claim 3 wherein the organic luminescent medium layer contains a first emitting material emitting light of the first color, a second emitting material emitting light of the second color and a third emitting material emitting light of the third color.

**5.** The organic electroluminescent display according to claim 3 wherein the first optical thickness adjustment layer comprises a first inorganic compound layer, and the second optical thickness adjustment layer comprises the first inorganic compound layer and a second inorganic compound layer.

**6.** An organic electroluminescent display comprising:

a first pixel comprising a first organic electroluminescent device and a first color filter which transmits light of a

first color emitted from the first organic electroluminescent device, provided in that order in a light-outcoupling direction;
a second pixel comprising a second organic electroluminescent device and a second color filter which transmits light of a second color emitted from the second organic electroluminescent device, provided in that order in the light-outcoupling direction; and
a third pixel comprising a third organic electroluminescent device and a third color filter which transmits light of a third color emitted from the third organic electroluminescent device, provided in that order in the light-outcoupling direction;
the first organic electroluminescent device sequentially comprising at least a reflecting electrode, first optical thickness adjustment layer, organic luminescent medium layer, metal layer and transparent electrode layer in the light-outcoupling direction,
the second organic electroluminescent device sequentially comprising at least a reflecting electrode, second optical thickness adjustment layer, organic luminescent medium layer, metal layer and transparent electrode layer in the light-outcoupling direction,
the third organic electroluminescent device sequentially comprising at least a reflecting electrode, third optical thickness adjustment layer, organic luminescent medium layer, metal layer and transparent electrode layer in the light-outcoupling direction,
the reflecting electrode having an average reflectance of 65% or more for light having a wavelength of 400 nm to 700 nm; and
the organic luminescent medium layer emitting light of at least the first color, the second color and the third color.

**7.** The organic electroluminescent display according to claim 6 wherein the organic luminescent medium layer contains a first emitting material emitting light of the first color, a second emitting material emitting light of the second color and a third emitting material emitting light of the third color.

**8.** The organic electroluminescent display according to claim 4 wherein the first optical thickness adjustment layer comprises a first inorganic compound layer, the second optical thickness adjustment layer comprises the first inorganic compound layer and a second inorganic compound layer, and the third optical thickness adjustment layer comprises the first inorganic compound layer, the second inorganic compound layer and a third inorganic compound layer.

**9.** The organic electroluminescent display according to claim 1, 3 or 6 wherein the organic luminescent medium layer sequentially comprises a blue emitting layer including a host material and a blue dopant, a green emitting layer including the same host material as in the blue emitting layer and a green dopant and an orange-to-red emitting layer including the same host material as in the blue emitting layer and an orange-to-red dopant.

**10.** The organic electroluminescent display according to claim 9 wherein the host material used for the organic luminescent medium layer is an asymmetric anthracene compound.

**11.** The organic electroluminescent display according to claim 9 wherein the blue dopant used for the organic luminescent medium is at least a compound selected from styrylamine, amine-substituted styryl compounds, amine-substituted condensed aromatic compounds and condensed aromatic ring-containing compounds.

**12.** The organic electroluminescent display according to claim 9 wherein the orange-to-red dopant used for the organic luminescent medium is at least a compound selected from compounds having a plurality of fluoranthene skeletons.

FIG. 1

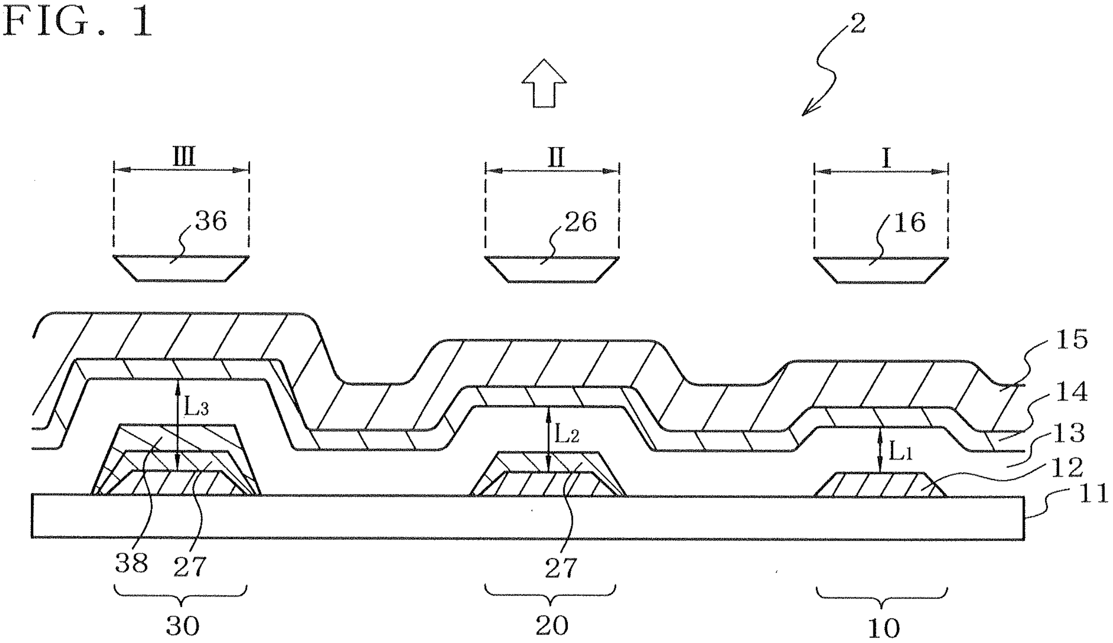


FIG. 2a

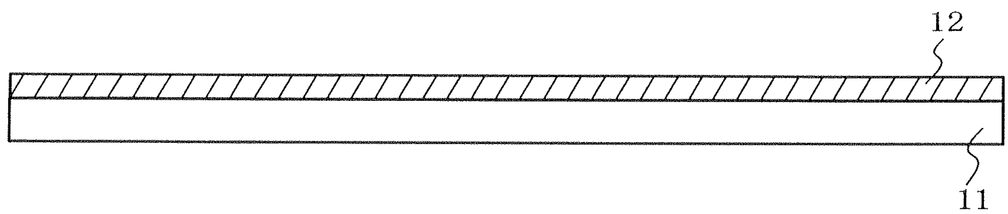


FIG. 2b

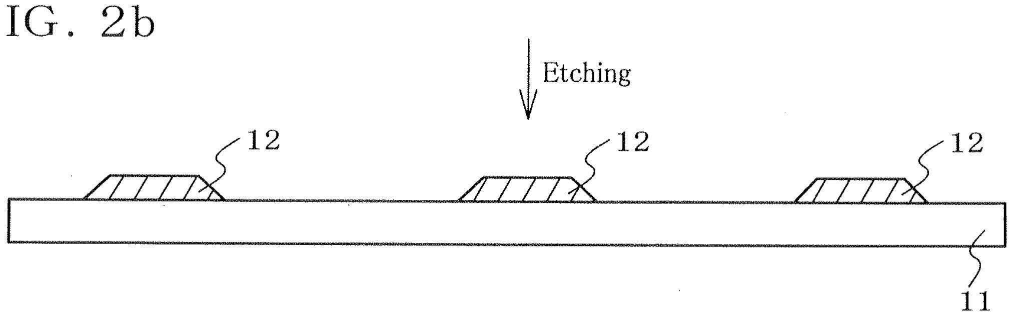


FIG. 2c

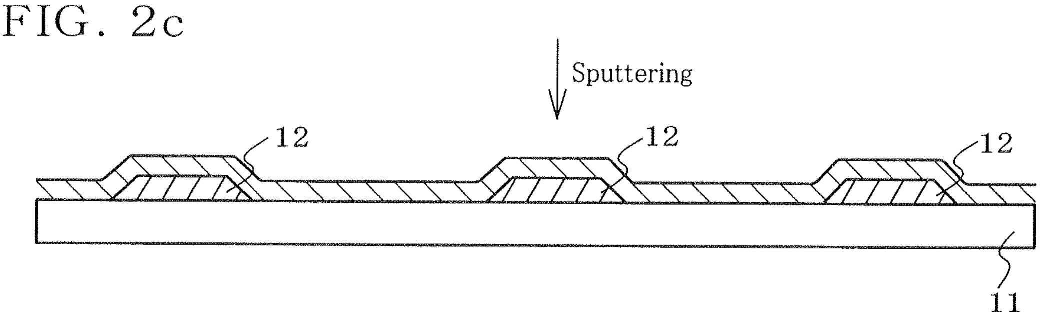

FIG. 2d

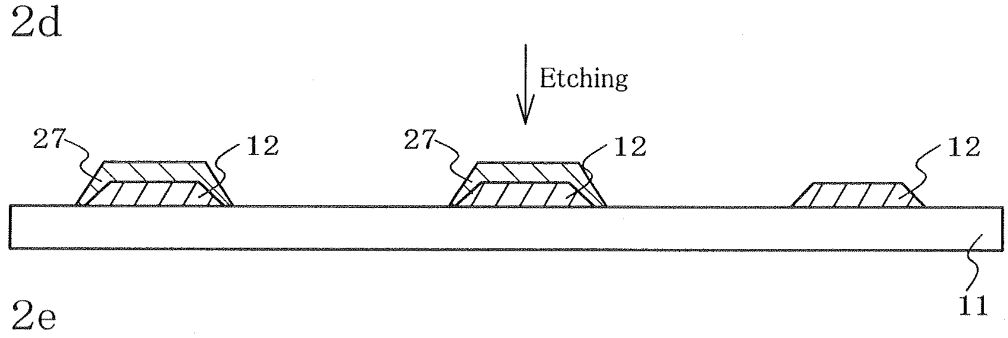


FIG. 2e

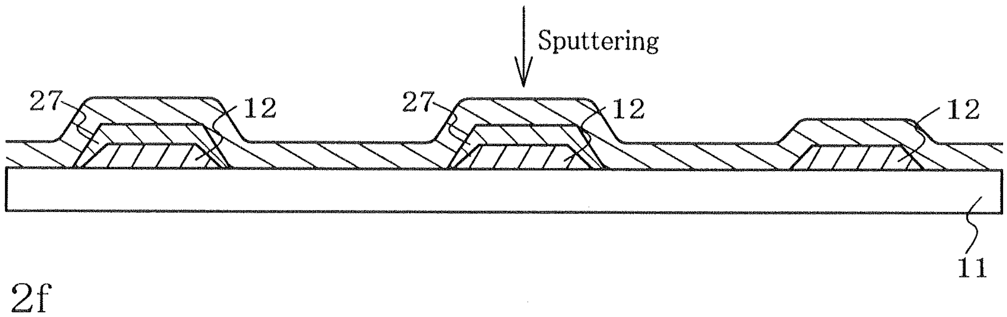


FIG. 2f

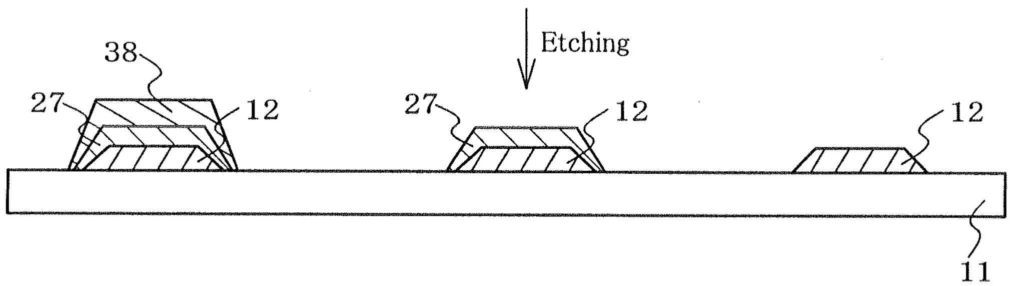


FIG. 2g

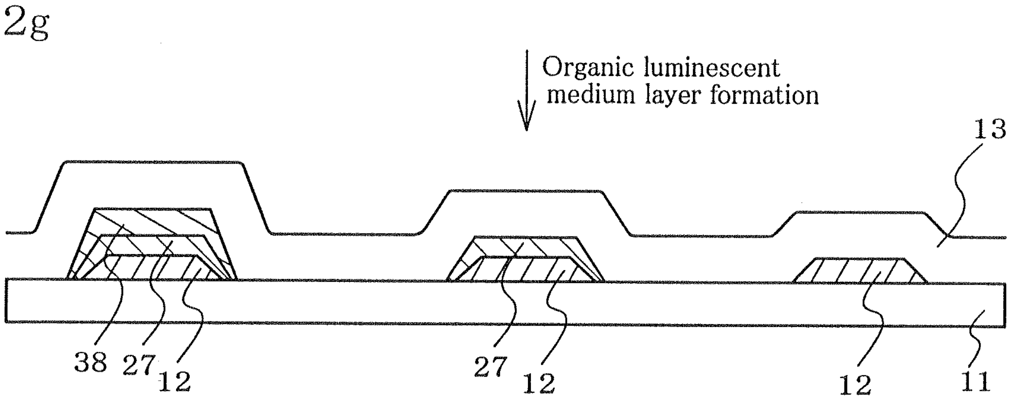

FIG. 2h

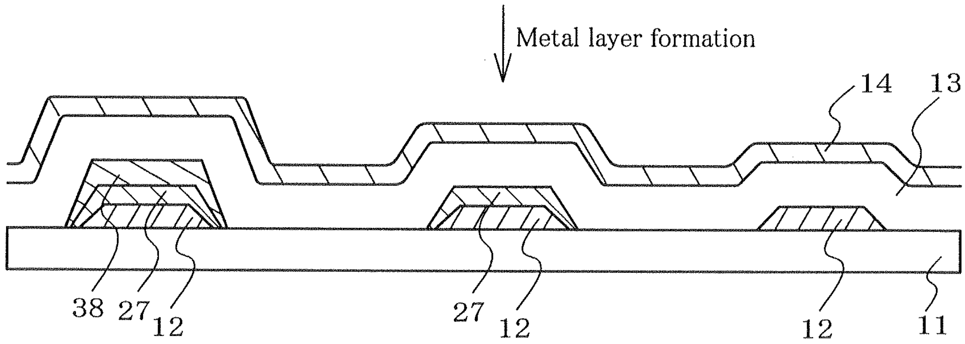


FIG. 2i

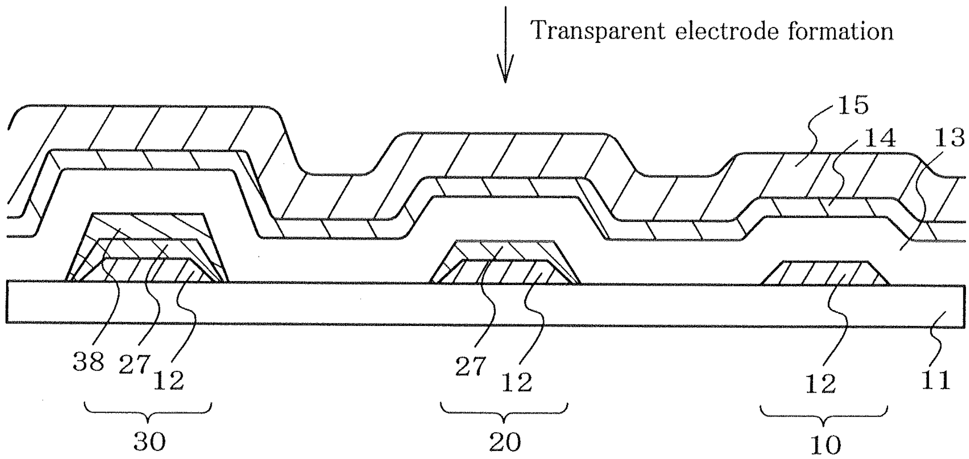


FIG. 3

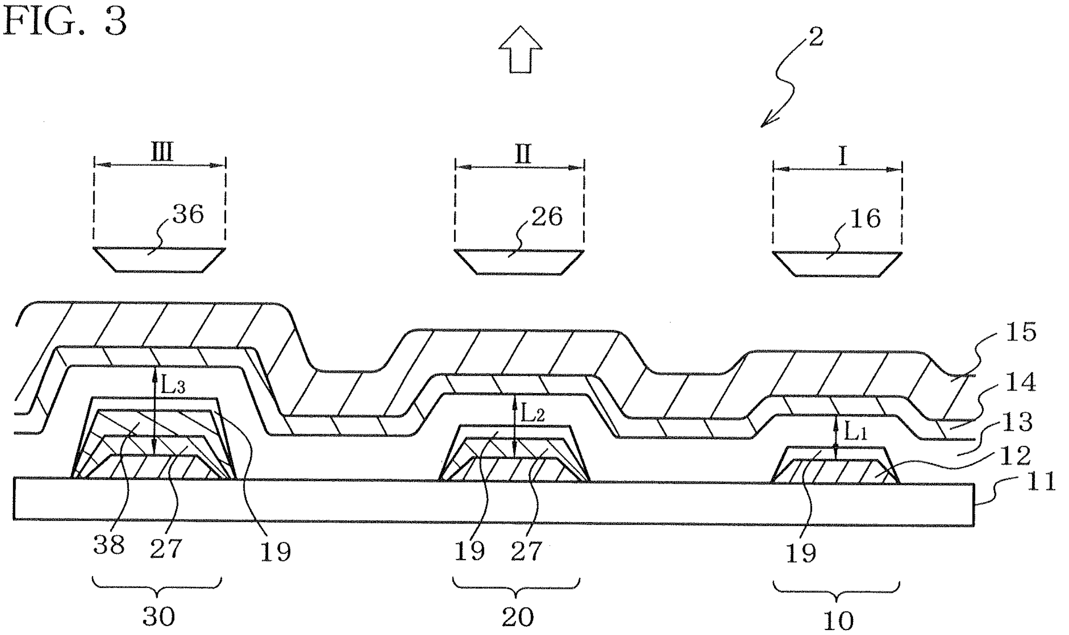

FIG. 4

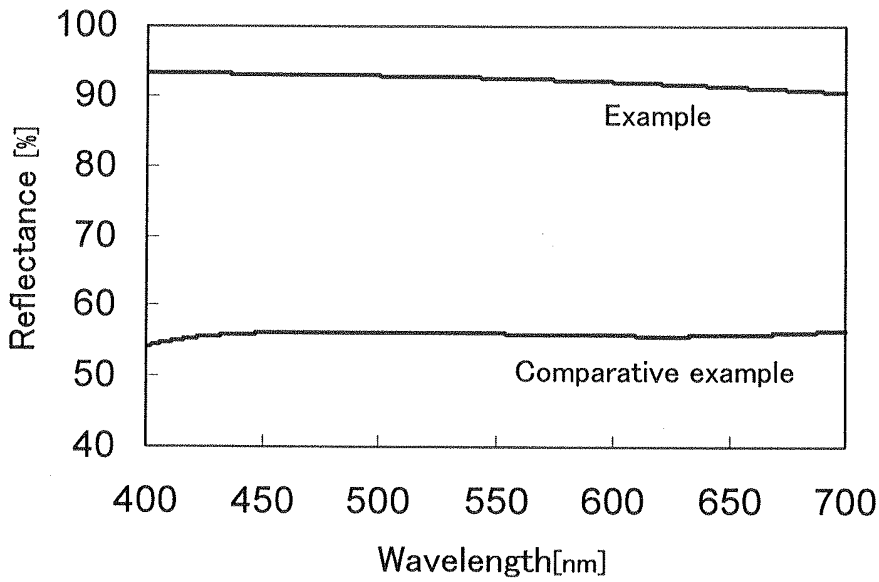
100
90
80
70
60
50
40
Reflectance [%]
Example
Comparative example
400
450
500
550
600
650
700
Wavelength[nm]

FIG. 5

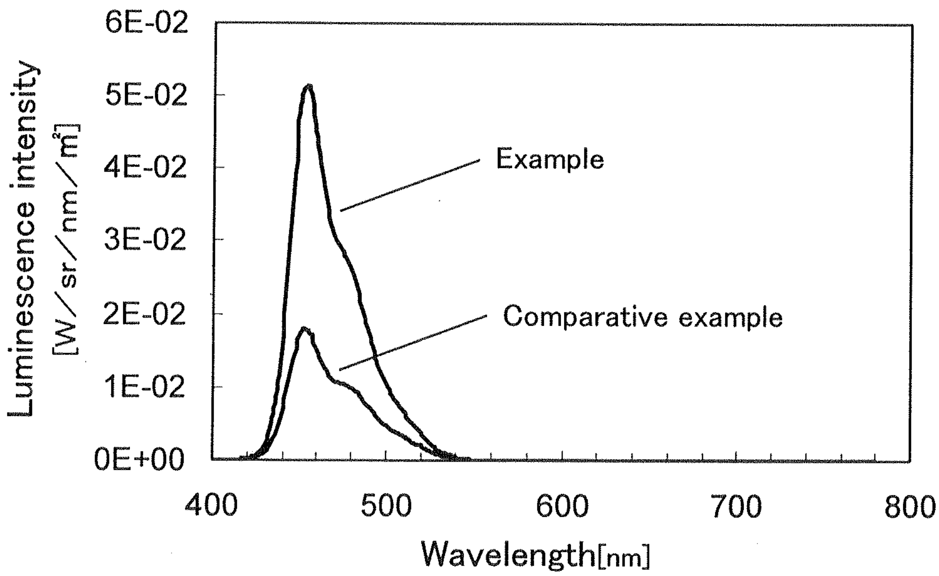
6E-02
5E-02
4E-02
3E-02
2E-02
1E-02
0E+00
Luminescence intensity
[W/sr/nm/m²]
Example
Comparative example
400
500
600
700
800
Wavelength[nm]

FIG. 6

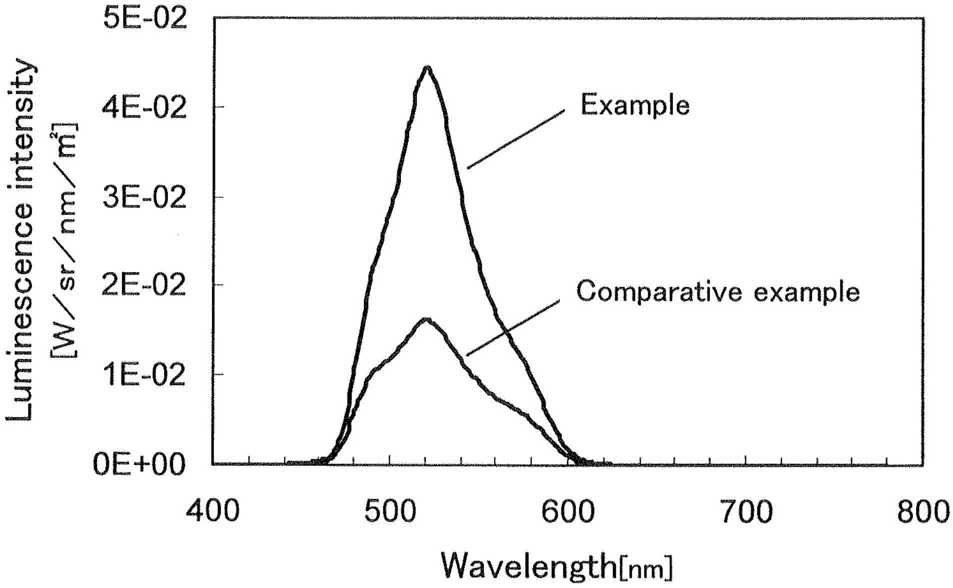
5E-02
4E-02
3E-02
2E-02
1E-02
0E+00
Luminescence intensity
[W/sr/nm/m²]
Example
Comparative example
400
500
600
700
800
Wavelength[nm]

FIG. 7

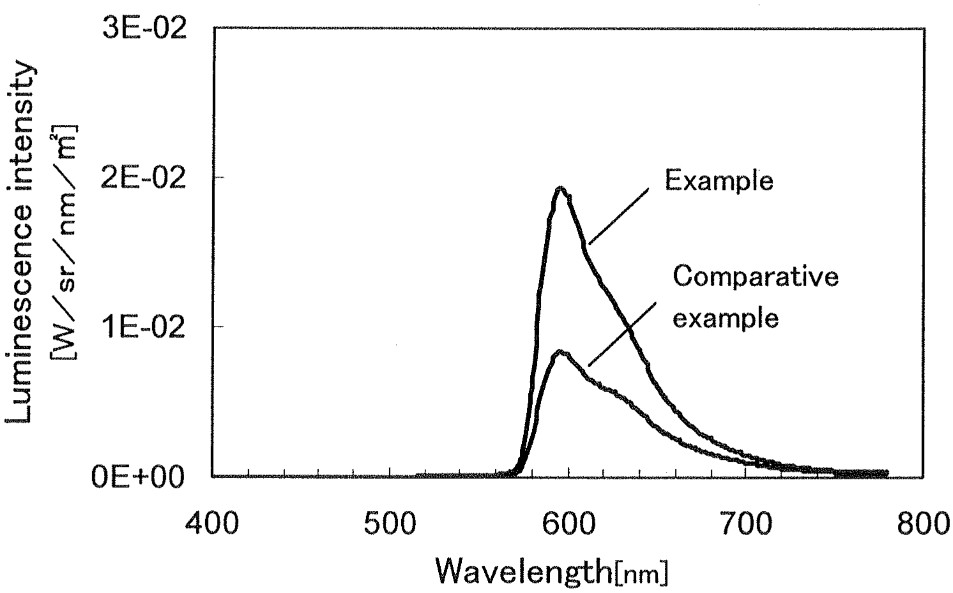
3E-02
2E-02
1E-02
0E+00
Luminescence intensity
[W/sr/nm/m²]
Example
Comparative
example
400
500
600
700
800
Wavelength[nm]

## INTERNATIONAL SEARCH REPORT

International application No.
PCT/JP2005/006846

A. CLASSIFICATION OF SUBJECT MATTER
Int.Cl$^7$ H05B33/24, 33/12, 33/14, 33/22

According to International Patent Classification (IPC) or to both national classification and IPC

B. FIELDS SEARCHED

Minimum documentation searched (classification system followed by classification symbols)
Int.Cl$^7$ H05B33/24, 33/12, 33/14, 33/22

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2003-508876 A (Seiko Epson Corp.),<br>04 March, 2003 (04.03.03),<br>Full text; all drawings<br>& GB 2353400 A & WO 2001/15246 A2<br>& AU 2000065818 A & EP 1145335 A2<br>& KR 2001093778 A & US 6639250 B1 | 1-4,6-7,9-12<br>5,8 |
| Y<br>A | JP 2003-528421 A (Seiko Epson Corp.),<br>24 September, 2003 (24.09.03),<br>Page 7, lines 13 to 22; Fig. 14<br>& GB 2351840 A & WO 2000/76010 A1<br>& AU 200052332 A & EP 1192675 A1<br>& KR 2002034088 A1 & US 6791261 B1<br>& KR 2002034088 A | 1-4,6-7,9-12<br>5,8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 August, 2005 (29.08.05) | 13 September, 2005 (13.09.05) |
| Name and mailing address of the ISA/<br>Japanese Patent Office<br>Facsimile No. | Authorized officer<br><br>Telephone No. |

Form PCT/ISA/210 (second sheet) (January 2004)

INTERNATIONAL SEARCH REPORT

International application No.
PCT/JP2005/006846

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 6-275381 A (Hitachi, Ltd.),<br>30 September, 1994 (30.09.94),<br>Full text; all drawings<br>& EP 616488 A2 & US 5554911 A<br>& DE 69410513 E | 1-4,6-7,9-12<br>5,8 |
| Y<br>A | JP 2001-71558 A (Futaba Corp.),<br>21 March, 2001 (21.03.01),<br>Par. Nos. [0010] to [0075]; Figs. 4, 6<br>(Family: none) | 1-4,6-7,9-12<br>5,8 |
| Y<br>A | JP 2003-272855 A (Fuji Electric Co., Ltd.),<br>26 September, 2003 (26.09.03),<br>Par. Nos. [0037] to [0039]; Fig. 2<br>& WO 2004/112441 A1 | 1-4,6-7,9-12<br>5,8 |
| Y<br>A | JP 2003-306454 A (Idemitsu Kosan Co., Ltd.),<br>28 October, 2003 (28.10.03),<br>Par. Nos. [0006] to [0054]<br>& WO 2003/087023 A1 & EP 1496041 A1<br>& KR 2005/000520 A | 1-4,6-7,9-12<br>5,8 |
| Y<br>A | JP 2003-272857 A (Idemitsu Kosan Co., Ltd.),<br>26 September, 2003 (26.09.03),<br>Claims 12, 13<br>(Family: none) | 1-4,6-7,9-12<br>5,8 |
| E,X | JP 2005-197010 A (Sanyo Electric Co., Ltd.),<br>21 July, 2005 (21.07.05),<br>Par. No. [0012]<br>(Family: none) | 5,8 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0139554 A
- JP 2001043980 A
- JP 2002373776 A
- JP 2004042694 A
- EP 0281381 A
- JP 2003249372 A
- US 3112197 A
- US 3189447 A
- JP 3716096 B
- US 3615402 A
- US 3820989 A
- US 3542544 A
- JP 45555 B
- JP 51010983 B
- JP 51093224 A
- JP 55017105 A
- JP 56004148 A
- JP 55108667 A
- JP 55156953 A
- JP 56036656 A
- US 3180729 A
- US 4278746 A
- JP 55088064 A
- JP 55088065 A
- JP 49105537 A
- JP 55051086 A
- JP 56080051 A
- JP 56088141 A
- JP 57045545 A
- JP 54112637 A
- JP 55074546 A
- US 3615404 A
- JP 51010105 B
- JP 46003712 B
- JP 47025336 B
- JP 54053435 A
- JP 54110536 A
- JP 54119925 A
- US 3567450 A
- US 3180703 A
- US 3240597 A
- US 3658520 A
- US 4232103 A
- US 4175961 A
- US 4012376 A
- JP 49035702 B
- JP 3927577 B
- JP 55144250 A
- JP 56119132 A
- JP 56022437 A
- DE 1110518
- US 3526501 A
- US 3257203 A
- JP 56046234 A
- JP 54110837 A
- US 3717462 A
- JP 54059143 A
- JP 55052063 A
- JP 55052064 A
- JP 55046760 A
- JP 55085495 A
- JP 57011350 A
- JP 57148749 A
- JP 2311591 A
- JP 61210363 A
- JP 61228451 A
- JP 61014642 A
- JP 61072255 A
- JP 62047646 A
- JP 62036674 A
- JP 62010652 A
- JP 62030255 A
- JP 60093455 A
- JP 60094462 A
- JP 60174749 A
- JP 60175052 A
- US 4950950 A
- JP 2204996 A
- JP 2282263 A
- JP 1211399 A
- JP 632956965 A
- US 4127412 A
- JP 53027033 A
- JP 54058445 A
- JP 54149634 A
- JP 54064299 A
- JP 55079450 A
- JP 61295558 A
- JP 61098353 A
- JP 63295695 A
- US 5061569 A
- JP 4308688 A
- JP 8193191 A